# EUROPEAN PATENT APPLICATION

(11) **EP 4 797 142 A1**
(43) Date of publication of application: **26.08.2026**
(21) Application number: 26160199.1
(22) Date of filing: 23.02.2026
(51) Int. Cl.: G06F 30/13, H04L 67/12, H04N 7/18

(54) **TOPOLOGICAL CONFIGURATION OF SECURITY SYSTEMS**

(30) Priority: 24.02.2025 US 202563762528 P; 31.10.2025 US 202519375685
(71) Applicant: Genetec Inc., Montréal, QC H4S 2A4 (CA)
(72) Inventor: MILLOT, Joffrey, 75020 Paris (FR)
(74) Representative: Grosfillier, Philippe

(57) **Abstract**

A physical security management system for securing a site monitored by security devices. The security management system comprises a topology database storing a topological model of the site; a network interface adapted for obtaining security data from the security devices; an input interface adapted for obtaining first user input from an input device defining first topological area and a relationship between the first topological area and at least one second topological area; a topology management engine coupled to the topological database, the topology management engine adapted for interpreting the first user input to configure the topological model to represent the first topological area and the relationship between the first topological area and the at least one second topological area; and an output interface adapted for causing display, via the display device, of at least part of the topological model following said updating thereof.

## Description

### Cross-Reference to Related Applications

The present application claims the benefit of co-pending US Provisional Patent Application ° 63/762,528, entitled "TOPOLOGICAL CONFIGURATION OF SECURITY SYSTEMS" and filed on 2025 February 24, and of co-pending US Regular Patent Application N° 19/375,685, entitled "TOPOLOGICAL CONFIGURATION OF SECURITY SYSTEMS", filed on 2025 October 31, the entire contents of which are hereby incorporated by reference herein.

### Field

The present disclosure relates generally to physical security and surveillance, and more specifically to security systems configurable by way of topological information.

### Background

A security system is a network of various devices employed to monitor and control activities and behaviours of persons, vehicles, or the like in a particular area being secured. A security system may collect security data from a variety of sources, centralize the data, and make the data available to security personnel to aid them in making decisions relating to the safety of persons or other objects within the area being monitored. A security system may include any suitable number of security devices for collecting information, including cameras, microphones, access card readers, and the like, any number of monitors or other interfaces for presenting security data to operators of the security system, as well as one or more security servers for facilitating operation and access to the security system. The security data produced by the security devices may be centralized in a physical security management system operated on the security server(s), for instance using a video management system (VMS) or a unified security platform (USP), which may primarily ensure the storage of video surveillance data acquired by cameras or similar security devices, but may also collect other types of security data, such as access control records, intrusion detection records, event records, records relating to intercom calls or other voice communications, and the like.

Deploying a new security system, or upgrading an existing security system, is typically a taxing endeavor. The security server must be configured to execute the software required to operate the physical security management system and to interface with all the security devices deployed as part of the security system. Additionally, the various security devices must also be provided with configuration settings to establish parameters for collecting security data and for communicating the security data to the security server. For deployments consisting of dozens, hundreds, or even thousands of security devices, this is considerable task.

While various suitable approaches for configuring security systems already exist, they exhibit a number of shortcomings. If the personnel performing the initial installation and configuration of the security system (installers) are not the same as the personnel tasked with operating the security system (operators), the names or other unique identifiers assigned by the installers to the various security devices may not be meaningful to the operators, causing confusion and lengthening the time required for operators to identify relevant security devices or data. The installers may be required to repeatedly enter identical configuration settings across multiple security devices, which are desired to operate in the same fashion, and operators may later need to manually update devices one at a time to effect a change across devices when the desired mode of operation changes. In addition, the security devices may only be presented in list form to operators, which is not conducive to a holistic and comprehensive understanding of the layout of the area being secured.

Thus, improved approaches for configuring and representing security systems are desirable.

### Summary

The following presents a simplified summary of one or more implementations in accordance with aspects of the present disclosure in order to provide a basic understanding of such implementations, without limiting the embodiments presented within the present disclosure. Although the following paragraphs may reference only some of methods, systems, or computer-readable media, it should be understood that the present disclosure may provide all of the above for implementing the functionality, capabilities, or the like that is described herein.

Physical security devices of various types, including security cameras, access control devices, and the like, may be used to monitor a site. Installation of the site may be performed by a consultant and involve the physical installation of the security devices, the coupling of the various security devices to a management system, which may involve one or more security servers, and the configuration of the security devices and the security server, including defining communication protocols, authentication rules, and the like. The physical layout of the site may inform decisions regarding the type and location of security devices within the site, but a logical representation of the site may further enhance these decisions.

To this end, the present disclosure provides methods, systems, and computer-readable media for establishing topological models for a site being monitored by security devices, as well as physical security management systems (and related methods and computer-readable media) for configuring and operating topological models. Topological models may be represented by a graph structure, composed of various nodes and edges connecting nodes. Nodes may be representative of topological areas, and edges of relationships therebetween. In some cases, the topological model may be hierarchical, such that geographical constructs (spaces, floors, buildings, sites, etc.) may be belong to other geographical constructs. For instance a building may be composed of multiple floors which belong thereto; similarly, a given floor of a building may be composed of multiple spaces, which belong thereto. Various approaches for displaying the topological models so established are described, including presenting topological models in conjunction with maps or floorplans of the spaces they represent.

The present disclosure therefore provides various methods, systems, and computer-readable media for establishing and operating topological models, including at least the following embodiments.

In accordance with a broad aspect, there is provided a physical security management system for securing a site monitored by security devices. The physical security management system comprises: a topology database storing a topological model of the site; a network interface adapted for obtaining security data from the security devices; an input interface adapted for obtaining first user input from an input device defining first topological area and a relationship between the first topological area and at least one second topological area; a topology management engine coupled to the topological database, the topology management engine adapted for interpreting the first user input to configure the topological model to represent the first topological area and the relationship between the first topological area and the at least one second topological area; and an output interface adapted for causing display, via the display device, of at least part of the topological model following said updating thereof.

In accordance with at least some of the of the embodiments described herein, the input interface is adapted for obtaining additional user input indicative of a first security device being located within the first area; the topology management engine is adapted for interpreting the additional user input to create an association between the first area and the first security device; and the output interface is adapted for causing the display device to display a visual representation of the first security device in association with the first area.

In accordance with at least some of the of the embodiments described herein, the physical security management system comprises a configuration database storing configuration data associated with the security devices; a configuration management engine coupled to the configuration database, the configuration management engine adapted for interpreting additional user input to update the configuration data associated with the security devices; wherein the network interface is adapted for providing the configuration data to the security devices.

In accordance with at least some of the of the embodiments described herein, the input interface is adapted for obtaining first relationship user input indicative of selection of a first relationship between a first pair of topological areas defined in the topological model; the input interface is adapted for obtaining second relationship user input indicative of a first security device being associated with the first relationship; the topology management engine is adapted for interpreting the first and second relationship user input to create an association between the first relationship and the first security device; and the output interface is adapted for causing the display device to display a visual representation of the first security device in association with the first relationship.

In accordance with at least some of the of the embodiments described herein, the second relationship user input is further indicative of a second security device being associated with the first relationship, and wherein the topology management engine is adapted for interpreting the second relationship user input to associate the first security device with a first side of the first relationship and to associate the second security device with a second side of the first relationship, the first and second sides being different.

In accordance with at least some of the of the embodiments described herein, the topological model comprises a graph structure composed of nodes representing areas and edges representing connections between areas, the first and second areas being a represented by a first and second node, respectively, in the topological model, and the first relationship is represented by an edge between the first and second node.

In accordance with at least some of the of the embodiments described herein, the graph structure is a unidirectional graph, wherein the first side of the first relationship is a first edge between the first and second node, and the second side of the first relationship is a second edge between the first and second node.

In accordance with at least some of the of the embodiments described herein, the topological model comprises a graph structure composed of nodes representing areas and edges representing connections between areas, the first and second areas being a represented by a first node and a second node, respectively, in the topological model, and a particular relationship being represented by an edge between the first and second nodes.

In accordance with at least some of the of the embodiments described herein, the graph structure is a unidirectional graph.

In accordance with at least some of the of the embodiments described herein, the output interface is adapted for causing display, via the display device, of a visual representation of a particular security device associated with the relationship between the first topological area and the at least one second topological area as being associated with the edge between the first and second nodes.

In accordance with at least some of the of the embodiments described herein, the input interface is adapted for obtaining third user input indicative of a selection of the edge between the first and second nodes, and wherein the output interface is adapted for, responsive to obtaining the third user input, causing display, via the display device, of relationship configuration parameters associated with the relationship between the first and second topological areas.

In accordance with at least some of the of the embodiments described herein, the topological model is a hierarchical topological model, the topology management engine being adapted for creating hierarchical relationships between first level geographical constructs and second level geographical constructs belonging to the first level geographical constructs, the input interface adapted for obtaining third user input defining a hierarchical relationship between a particular first level geographical construct and a particular second level geographical construct belonging to the particular first level geographical construct.

In accordance with at least some of the of the embodiments described herein, the third user input defines the particular first level geographical construct and defines the first area as the particular second level geographical construct.

In accordance with at least some of the of the embodiments described herein, the third user input further defines the second area as another second level geographical construct belonging to the particular first level geographical construct.

In accordance with at least some of the of the embodiments described herein, the output interface is adapted for causing display, via the display device, of the hierarchical topological model, comprising displaying a visual representation of first area as being nested within a visual representation of the particular first level geographical construct.

In accordance with at least some of the of the embodiments described herein, the physical security management system further comprising a map representation component adapted for accessing stored map data and representing the map data as a map on the display device via the output interface, the map data being distinct from the topological model and defining spatial attributes of the site, the topological model defining logical connectivity relationships for the site.

In accordance with at least some of the of the embodiments described herein, the physical security management system further comprising processing map data to automatically derive therefrom the first topological area and the second topological area and the relationship between the first topological area and the second topological area.

In accordance with at least some of the of the embodiments described herein, wherein the input interface is adapted for obtaining further user input indicative of at least one of a subsequent topological area and a relationship between the subsequent topological area and at least one existing topological area, wherein the topology management engine is adapted for interpreting the further user input and further updating the topological model to represent the subsequent topological area and the relationship between the subsequent topological area and the at least one existing topological area, and wherein the output interface is adapted for causing display of the at least part of the topological mode, including the subsequent topological area, following said further updating thereof.

In accordance with at least some of the of the embodiments described herein, the first user input obtained by the input interface is indicative of the first topological area being one of a site, a building, a floor, a room, and of the relationship being one of a closed connection and an open connection.

In accordance with another broad aspect, there is provided a security system for securing a site, comprising a plurality of security devices monitoring the site; and the physical security management system as defined in accordance with at least some of the of the embodiments described herein.

In accordance with a further broad aspect, there is provided a method for establishing a topological model for a site being monitored by a plurality of security device, comprising: obtaining first user input defining a first topological area and a relationship between the first topological area and at least one second topological area of the topological model; interpreting the first user input to update the topological model to represent the first topological area and the relationship between the first topological area and the at least one second topological area; and causing display of at least part of the topological model following updating thereof.

In accordance with at least some of the embodiments described herein, the method further comprising obtaining additional user input indicative of a first security device being located within the first area; interpreting the additional user input to create an association between the first area and the first security device; and causing the display device to display a visual representation of the first security device in association with the first area.

In accordance with at least some of the embodiments described herein, the method further comprising storing configuration data associated with the security devices; interpreting additional user input to update the configuration data associated with the security devices; and providing the configuration data to the security devices.

In accordance with at least some of the embodiments described herein, the method further comprising obtaining first relationship user input indicative of selection of a first relationship between a first pair of topological areas defined in the topological model; obtaining second relationship user input indicative of a first security device being associated with the first relationship; interpreting the first and second relationship user input to create an association between the first relationship and the first security device; and causing the display device to display a visual representation of the first security device in association with the first relationship.

In accordance with at least some of the embodiments described herein, wherein the second relationship user input is further indicative of a second security device being associated with the first relationship, and wherein the method further comprises interpreting the second relationship user input to associate the first security device with a first side of the first relationship and to associate the second security device with a second side of the first relationship, the first and second sides being different.

In accordance with at least some of the embodiments described herein, wherein the topological model comprises a graph structure composed of nodes representing areas and edges representing connections between areas, the first and second areas being a represented by a first and second node, respectively, in the topological model, and the first relationship is represented by an edge between the first and second node.

In accordance with at least some of the embodiments described herein, wherein the graph structure is a unidirectional graph, wherein the first side of the first relationship is a first edge between the first and second node, and the second side of the first relationship is a second edge between the first and second node.

In accordance with at least some of the embodiments described herein, wherein the topological model comprises a graph structure composed of nodes representing areas and edges representing connections between areas, the first and second areas being a represented by a first node and a second node, respectively, in the topological model, and a particular relationship being represented by an edge between the first and second nodes.

In accordance with at least some of the embodiments described herein, wherein the graph structure is a unidirectional graph.

In accordance with at least some of the embodiments described herein, the method further comprising causing display, via the display device, of a visual representation of a particular security device associated with the relationship between the first topological area and the at least one second topological area as being associated with the edge between the first and second nodes.

In accordance with at least some of the embodiments described herein, the method further comprising obtaining third user input indicative of a selection of the edge between the first and second nodes, and responsive to obtaining the third user input, causing display, via the display device, of relationship configuration parameters associated with the relationship between the first and second topological areas.

In accordance with at least some of the embodiments described herein, wherein the topological model is a hierarchical topological model, the method further comprising creating hierarchical relationships between first level geographical constructs and second level geographical constructs belonging to the first level geographical constructs and defining a hierarchical relationship between a particular first level geographical construct and a particular second level geographical construct belonging to the particular first level geographical construct.

In accordance with at least some of the embodiments described herein, wherein the third user input defines the particular first level geographical construct and defines the first area as the particular second level geographical construct.

In accordance with at least some of the embodiments described herein, wherein the third user input further defines the second area as another second level geographical construct belonging to the particular first level geographical construct.

In accordance with at least some of the embodiments described herein, the method further comprising causing display, via the display device, of the hierarchical topological model, comprising displaying a visual representation of first area as being nested within a visual representation of the particular first level geographical construct.

In accordance with at least some of the embodiments described herein, the method further comprising accessing stored map data and representing the map data as a map on the display device, the map data being distinct from the topological model and defining spatial attributes of the site, the topological model defining logical connectivity relationships for the site.

In accordance with at least some of the embodiments described herein, the method further comprising processing map data to automatically derive therefrom the first topological area and the second topological area and the relationship between the first topological area and the second topological area.

In accordance with at least some of the embodiments described herein, the method further comprising obtaining further user input indicative of at least one of a subsequent topological area and a relationship between the subsequent topological area and at least one existing topological area, interpreting the further user input and further updating the topological model to represent the subsequent topological area and the relationship between the subsequent topological area and the at least one existing topological area, and causing display of the at least part of the topological model, including the subsequent topological area, following said further updating thereof.

In accordance with at least some of the embodiments described herein, wherein the first user input obtained is indicative of the first topological area being one of a site, a building, a floor, a room, and of the relationship being one of a closed connection and an open connection.

In accordance with a still further broad aspect, there is provided a method for configuring a physical security management system, comprising: displaying a graphical user interface for receiving user input, the graphical user interface configured to progress through a plurality of pages soliciting user input relating to a site being monitored; obtaining, via a first page of the plurality of pages, first user input indicative of a layout of the site; generating, based on the first user input, a topological model of the site being monitored representative of the layout; obtaining, via a second page of the plurality of pages, second user input indicative of one or more topological areas within the site being monitored; generating, based on the second user input, one or more constituent elements representative of the one or more topological areas within the topological model of the site being monitored; obtaining, via a third page of the plurality of pages, third user input indicative of an association of at least one physical security device with a respective one of the one or more constituent elements; and assigning, based on the third user input, the at least one physical security device to the respective one of the one or more constituent elements within the topological model of the site being monitored.

In accordance with at least some of the of the embodiments described herein, displaying the graphical user interface comprises displaying an index comprising an indicator of a current page within the graphical user interface.

In accordance with at least some of the of the embodiments described herein, displaying the index comprises displaying indicators for the plurality of pages within the graphical user interface.

In accordance with at least some of the of the embodiments described herein, the second user input is indicative of a number of buildings composing the site, and wherein generating the one or more constituent elements comprises generating, within the topological model, building nodes corresponding to the number of buildings.

In accordance with at least some of the of the embodiments described herein, the second user input is indicative of a number of floors composing a building of the site, and wherein generating the one or more constituent elements comprises generating, within the topological model, floor nodes corresponding to the number of buildings and relationships between the floor nodes and a building node representing the building.

In accordance with at least some of the of the embodiments described herein, the second user input is indicative of a number of spaces composing a floor of the site, and wherein generating the one or more constituent elements comprises generating, within the topological model, space nodes corresponding to the number of buildings and relationships between the space nodes and a floor node representing the floor.

In accordance with at least some of the of the embodiments described herein, the method comprises: obtaining, via a fourth page of the plurality of pages, fourth user input indicative of a relationship between a first space and a second space of the site; and generating, based on the fourth user input, a representation of the relationship between the first space and the second space within the topological model.

In accordance with at least some of the of the embodiments described herein, the fourth user input is indicative of a security device mediating the relationship between the first space and the second space, comprising generating an association between the security device and the relationship within the topological model.

In accordance with at least some of the of the embodiments described herein, the fourth user input is indicative of a side of the relationship with which the security device is associated, wherein generating the association comprises associating the security device with one of the first space and the second space.

In accordance with at least some of the of the embodiments described herein, the fourth user input is indicative of the security device being one of an access control reader, a request-to-exit sensor, an entry sensor, a camera, and a door controller.

In accordance with at least some of the of the embodiments described herein, the method comprises obtaining, via a fourth page of the plurality of pages, fourth user input indicative of a location of the site; and associating the location with the topological model of the site being monitored.

In accordance with at least some of the of the embodiments described herein, the fourth user input comprises a georeferenced location.

In accordance with at least some of the of the embodiments described herein, the fourth user input comprises a civic address.

In accordance with at least some of the of the embodiments described herein, the method comprises presenting, via a fourth page of the plurality of pages, confirmation information relating to at least some of the first user input, the second user input, and the third user input.

In accordance with at least some of the of the embodiments described herein, the topological model comprises a graph structure composed of nodes representing the one or more constituent elements and edges representing relationships between the one or more constituent elements.

In accordance with at least some of the of the embodiments described herein, generating one or more constituent elements comprises generating a root node within the topological model as a first constituent element.

In accordance with at least some of the of the embodiments described herein, generating the one or more constituent elements comprises generating one or more leaf nodes, wherein at least one of the leaf nodes is linked to the root node.

In accordance with at least some of the of the embodiments described herein, the method comprises accessing map data defining a map of the site, the map data being distinct from the topological model and defining spatial attributes of the site; displaying at least a portion of the map data as a map on the graphical user interface; and obtaining via the user input a relationship between at least one constituent element within the topological model and a portion of the map and in response associating the at least one constituent element to the portion of the map.

In accordance with another broad aspect, there is provided a system for configuring a physical security management system, comprising a processor and a non-transitory computer-readable memory containing instructions which, when executed by the processor, cause the system to perform: displaying a graphical user interface for receiving user input, the graphical user interface configured to progress through a plurality of pages soliciting user input relating to a site being monitored; obtaining, via a first page of the plurality of pages, first user input indicative of a layout of the site; generating, based on the first user input, a topological model of the site being monitored representative of the layout; obtaining, via a second page of the plurality of pages, second user input indicative of one or more topological areas within the site being monitored; generating, based on the second user input, one or more constituent elements representative of the one or more topological areas within the topological model of the site being monitored; obtaining, via a third page of the plurality of pages, third user input indicative of an association of at least one physical security device with a respective one of the one or more constituent elements; and assigning, based on the third user input, the at least one physical security device to the respective one of the one or more constituent elements within the topological model of the site being monitored.

In accordance with at least some of the of the embodiments described herein, wherein displaying the graphical user interface comprises displaying an index comprising an indicator of a current page within the graphical user interface.

In accordance with at least some of the of the embodiments described herein, wherein displaying the index comprises displaying indicators for the plurality of pages within the graphical user interface.

In accordance with at least some of the of the embodiments described herein, wherein the second user input is indicative of a number of buildings composing the site, and wherein generating the one or more constituent elements comprises generating, within the topological model, building nodes corresponding to the number of buildings.

In accordance with at least some of the of the embodiments described herein, wherein the second user input is indicative of a number of floors composing a building of the site, and wherein generating the one or more constituent elements comprises generating, within the topological model, floor nodes corresponding to the number of buildings and relationships between the floor nodes and a building node representing the building.

In accordance with at least some of the of the embodiments described herein, wherein the second user input is indicative of a number of spaces composing a floor of the site, and wherein generating the one or more constituent elements comprises generating, within the topological model, space nodes corresponding to the number of buildings and relationships between the space nodes and a floor node representing the floor.

In accordance with at least some of the of the embodiments described herein, wherein when executed by the processor, the instructions further cause the system to perform obtaining, via a fourth page of the plurality of pages, fourth user input indicative of a relationship between a first space and a second space of the site; and generating, based on the fourth user input, a representation of the relationship between the first space and the second space within the topological model.

In accordance with at least some of the of the embodiments described herein, wherein the fourth user input is indicative of a security device mediating the relationship between the first space and the second space, comprising generating an association between the security device and the relationship within the topological model.

In accordance with at least some of the of the embodiments described herein, wherein the fourth user input is indicative of a side of the relationship with which the security device is associated, wherein generating the association comprises associating the security device with one of the first space and the second space.

In accordance with at least some of the of the embodiments described herein, wherein the fourth user input is indicative of the security device being one of an access control reader, a request-to-exit sensor, an entry sensor, a camera, and a door controller.

In accordance with at least some of the of the embodiments described herein, wherein when executed by the processor, the instructions further cause the system to perform obtaining, via a fourth page of the plurality of pages, fourth user input indicative of a location of the site; and associating the location with the topological model of the site being monitored.

In accordance with at least some of the of the embodiments described herein, wherein the fourth user input comprises a georeferenced location.

In accordance with at least some of the of the embodiments described herein, wherein the fourth user input comprises a civic address.

In accordance with at least some of the of the embodiments described herein, wherein when executed by the processor, the instructions further cause the system to perform presenting, via a fourth page of the plurality of pages, confirmation information relating to at least some of the first user input, the second user input, and the third user input.

In accordance with at least some of the of the embodiments described herein, wherein the topological model comprises a graph structure composed of nodes representing the one or more constituent elements and edges representing relationships between the one or more constituent elements.

In accordance with at least some of the of the embodiments described herein, wherein generating one or more constituent elements comprises generating a root node within the topological model as a first constituent element.

In accordance with at least some of the of the embodiments described herein, wherein generating the one or more constituent elements comprises generating one or more leaf nodes, wherein at least one of the leaf nodes is linked to the root node.

In accordance with at least some of the of the embodiments described herein, wherein when executed by the processor, the instructions further cause the system to perform accessing map data defining a map of the site, the map data being distinct from the topological model and defining spatial attributes of the site, displaying at least a portion of the map data as a map on the graphical user interface, and obtaining via the user input a relationship between at least one constituent element within the topological model and a portion of the map and in response associating the at least one constituent element to the portion of the map.

Computer readable media containing instructions for implementing any of the embodiments described herein are also provided.

These and other aspects of the present disclosure are described in detail below and are also part of the present teachings, the scope of which are presented in the appended claims.

### Brief Description of the Drawings

For a more complete understanding of the present disclosure, reference is now made to the accompanying drawings. The following brief descriptions of the drawings should not be considered limiting in any fashion.
[Fig 1] is a block diagram of an example security system.
[Fig 2] is a block diagram of an example physical security management system implemented by the server of [Fig 1].
[Fig 3] is an example graphical user interface for operating the physical security management system of [Fig 2].
[Fig 4A] to [Fig 4C] are example graphical user interfaces for creating a site within the physical security management system of [Fig 2].
[Fig 5A] to [Fig 5F] are example graphical user interfaces for managing a site within the physical security management system of [Fig 2].
[Fig 6A] to [Fig 6I] are example graphical user interfaces for managing and visualizing a site within the physical security management system of [Fig 2].
[Fig 7A] to [Fig 7C] are example alternative graphical user interfaces for visualizing a site within the physical security management system of [Fig 2].
[Fig 8] is a further alternative example graphical user interface for managing and visualizing a site within the physical security management system of [Fig 2].
[Fig 9A] to [Fig 9C] are example graphical user interfaces for visualizing a site using a floor plan within the physical security management system of [Fig 2].
[Fig 10A] to [Fig 10E] are example graphical user interfaces for managing a site using a floor plan within the physical security management system of [Fig 2].
[Fig 11] is an alternative example graphical user interface for managing a site within the physical security management system of [Fig 2].
[Fig 12] is a block diagram of an example computing system.
[Fig 13] is a flowchart illustrating an example method for establishing a topological model for a site being monitored by a plurality of security devices.
[Fig 14A] to [Fig 14E] are example configuration wizards for configuring the site being monitored.
[Fig 15A] to [Fig 15C] are example configuration wizards for modifying a topological model associated with the site.
[Fig 16A] to [Fig 16E] are example configuration wizards for associating security devices with relationships within the topological model associated with the site.
[Fig 17] is a flowchart illustrating an example method for configuring a physical security management system.

It will be noted that throughout the appended drawings that like features are identified by like reference numerals.

### Detailed Description

The present disclosure relates to, *inter alia*, methods, systems, devices, and computer-readable media for securing a site. The site may be at a single location, a collection of nearby or adjoining locations, at a plurality of distributed locations, or the like. The site may be monitored by one or more security devices, including security cameras and other surveillance video devices, microphones and other audio recording devices, license plate recognition devices, and the like. To facilitate and improve the task of security operators in adequately monitoring the site, the present disclosure provides various graphical user interfaces (GUIs) through which the site can be managed and through which information pertaining to the site can be visualized.

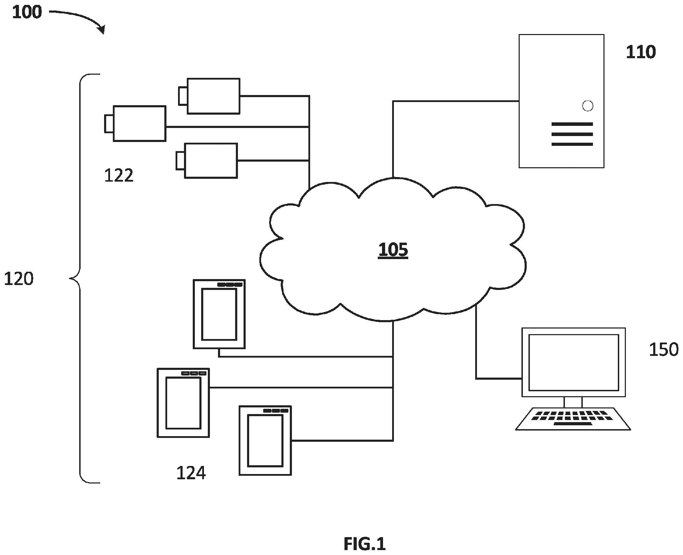

With reference to [Fig 1], an example implementation of the security system 100 is illustrated as containing a security server 110, security devices 120, and a client device 150, all of which communicate over a network 105. Although illustrated in [Fig 1] as being composed of cameras 122 and access control readers 124, it should be understood that the security system 100 may include any suitable type of security devices 120, and any suitable number of security devices 120 may form part of the security system 100. Additionally, although a single security server 110 is illustrated, it should be understood that the security system 100 may include any number of servers 110, which may be distributed or collocated, and which may substantially share in all the functionality described herein, or may be differentiated by which functionality each server 110 performs. The client device 150 may be any suitable type of computing device by which a user may interact with the other elements of the security system 100, including a desktop computer, laptop computer, smartphone, tablet, or the like.

The network 105 may be any suitable type of network for facilitating communication between the security devices 120, the security server 110, and the client device 150. In some embodiments, the network 105 is a local network, whereas in other embodiments, the network 105 may span various local and public networks, including the Internet. The network 105 may employ wired connections, wireless connections, or a combination of wired and wireless connections, as appropriate.

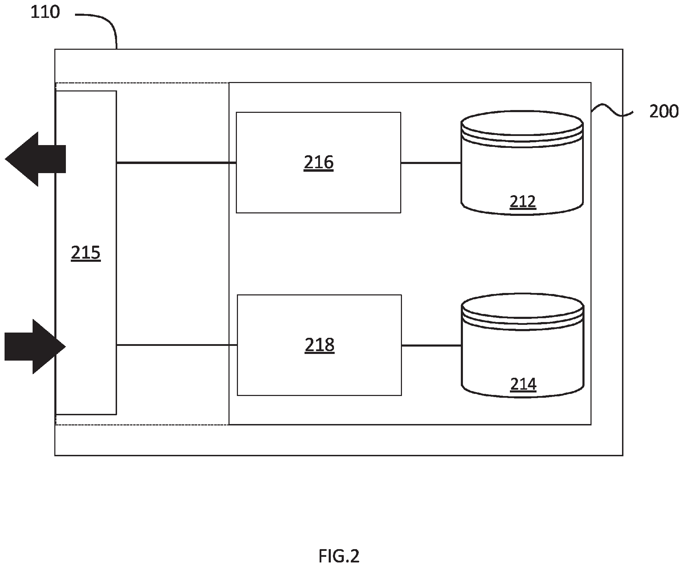

With reference to [Fig 2], the security server 110 may implement a physical security management system 200, composed of a topology database 212, a configuration database 214, a topology management engine 216, and a configuration management engine 218. The physical security management system 200 may also, in some embodiments, be considered as including one or more interfaces 215 of the security server 110. The interfaces 215 may include one or more network interfaces, one or more input interfaces, one or more output interfaces, and may include in any combination both wired and wireless interfaces, as appropriate. The interfaces 215 may facilitate exchange of information between the other elements of the physical security management system 200 and the remainder of the security system 100 over the network 105, as well as with other input and output devices, as appropriate.

The topology database 212 is configured for storing a topological model of the site being monitored. A topological model is a representation of the physical areas which compose the site and of the relationships between the physical areas. In some embodiments, the topological model may also represent the scale of the site. Additionally, the topological model may store the location of the security devices 120, within the site; that is to say, to represent the distribution of the security devices 120 within the various areas that compose the site. In some embodiments, the topological model may be a hierarchical model. For instance, the model may define a site as containing one or more buildings; each building as containing one or more floors; and each floor as containing one or more spaces. Although the discussion herein will employ the terms "area" or "areas" when discussing the elements of the topological model, it should be understood that in embodiments in which a hierarchical topological model is employed, these terms may be substituted for other terms, for instance "site", "building", "floor", and/or "space", as appropriate.

The topological model may be structured in any suitable fashion. For example, the topological model may be logically and/or visually represented by at least one graph having nodes and edges. Each node corresponds to a space, and each edge corresponds to a connective element between two spaces. Edges may be unidirectional or bidirectional, though in some implementations, a bidirectional connection between two spaces may be represented as two unidirectional edges having opposing directions. Thus, spaces, floors, buildings, sites, etc., may each be represented by nodes, and the relationships between the different topological areas may be defined via edges. Different types of relationships may exist: for instance, some relationships may be controlled (i.e., mediated), whereas other relationships may not be controlled (or may be said to be uncontrolled). For example, two spaces separated by an access-controlled door may be said to have a controlled relationship, whereas two spaces separated by a doorway may have an uncontrolled relationship.

The topology may be implemented using the Indoor Geography Markup Language (IndoorGML) standard or any other suitable markup language to represent a topology of a secured premises. The IndoorGML standard is an Open Geospatial Consortium (OGC) standard that provides a schema for representing indoor spaces. IndoorGML focuses on representing the topological relationships between indoor spaces, such as rooms and corridors, by way of a node-relation graph (NRG) describing adjacency and connectivity. However, IndoorGML has been used primarily for applications like navigation, routing and pathfinding, and not for physical access control enforcement.

The topological model stored in the topology database 212 may be updated by way of the topology management engine 216, which is coupled thereto. The physical security management system 200 may obtain various user input relating to the topological model, as will be described hereinbelow. The topology management engine 216 may obtain the user input, for instance via the interfaces 215, and may be configured for interpreting the user input and for updating the topological model stored in the topology database 212 accordingly. For instance, a user may create a new site, add one or more areas to a site, create relationships between areas, remove or combine one or more areas, associate security devices with areas, and the like.

The configuration database 214 is configured for storing configuration data associated with the security devices 120. The configuration data stored in the configuration database 214 may include information for facilitating communication between the security server 110 and the security devices 120, settings or other operational parameters for the security devices, 120, and the like. The configuration data may be updated by way of the configuration management engine 218, which is coupled thereto. The physical security management system 200 may obtain various user input relating to the configuration of the security devices 120, as will be described hereinbelow. The configuration management engine 218 may obtain the user input, for instance via the interfaces 215, and may be configured for interpreting the user input and for updating the configuration data stored in the configuration database 214 accordingly. For instance, a user may create a change the bitrate at which one of the cameras 122 records surveillance video, update the credentials used to access a particular security device 120, and the like.

In operation, the physical security management system 200 is configured for displaying one or more visualizations of the site being monitored via a display device for presentation to a user. The visualizations are based on the topological model of the site, stored in the topology database 212, and may take on many forms. When user input indicative of interaction with one of the visualizations is obtained, the physical security management system 200 may cause the visualization to be adjusted, modified, or updated in various ways. For instance, a user may click-and-drag on a portion of the visualization, causing the portion to be repositioned, and thereafter the rest of the visualization may also be repositioned as a result.

In addition, the physical security management system 200 may solicit and obtain user input indicative of changes to be made to the topological model stored in the topology database 212 and/or to the configuration data stored in the configuration database 214. The user input may then be interpreted by the topology management engine 216 and/or by configuration management engine 218, as appropriate, to effect changes in the topological model and/or the configuration data. For example, user input indicative of addition of an area to the topological model can be obtained; the topology management engine 216 may interpret the user input and update the topological model to create the additional area. By way of another example, user input indicative of a relationship between an area and a security device, between two areas, and the like, can be obtained; the topology management engine 216 may interpret the user input and update the topological model to create the relationship. By way of a further example, user input indicative of a change to the settings of a camera can be obtained; the configuration management engine 218 may interpret the user input and update the configuration data accordingly, then send, via the interfaces 215, a command to the camera to cause it to update its settings. Other examples are considered.

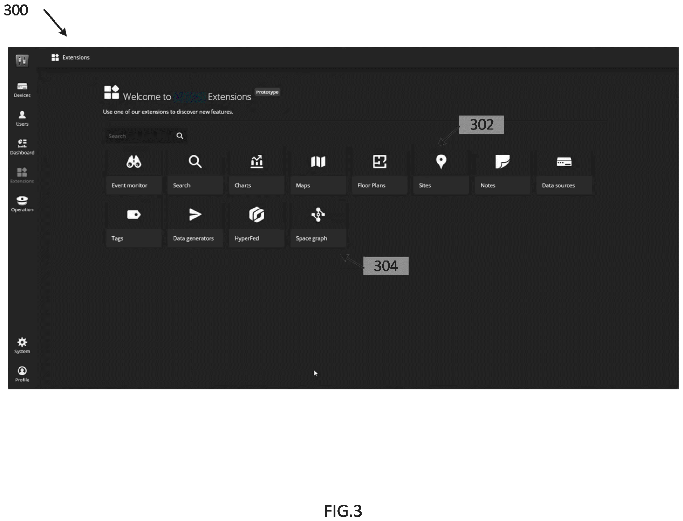

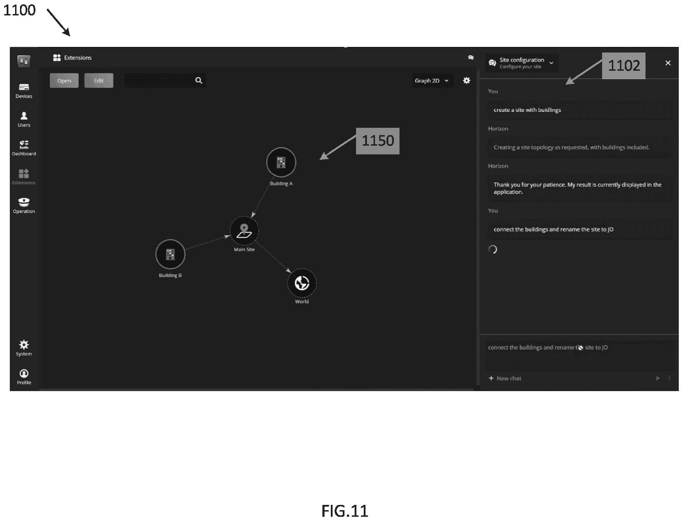

As illustrated in [Fig 3] to [Fig 11], the physical security management system 200 may present various GUIs through which a user may provide input for operating the physical security management system 200, including to update the topological model and the configuration data. The GUIs illustrated in [Fig 3] to [Fig 11] are presented as examples, and it should be understood that variations from the particulars of the examples in [Fig 3] to [Fig 11] remain within the scope of the present disclosure. Additionally, it should be understood that the various GUIs illustrated in [Fig 3] to [Fig 11] may be produced by the physical security management system 200 for presentation on any suitable type of display device, for instance via the interfaces 215. For example, the physical security management system 200 may produce the GUIs for display via a display device of the client device 150, via a display device coupled to the physical security management system 200, or the like. Alternatively, the various GUIs illustrated in [Fig 3] to [Fig 11] may be produced by the client device 150 for presentation on any suitable type of display device coupled thereto. Alternatively still, the various GUIs illustrated in [Fig 3] to [Fig 11] may be produced by another device of the security system 100, as appropriate.

With reference to [Fig 3], the physical security management system 200 may present a GUI 300 presenting a variety of tools or functions available to a user, including a Sites feature 302 and a Space Graph feature 304. Other functions are also illustrated, but may not be discussed in detail herein. By selecting one of the functions, the GUI 300 may transition to another GUI, as described herein. In some embodiments, in order to access the GUI 300, as well as any of the other GUIs described herein, the user may need to provide credentials, such as a user account and password. The permissions made available to the user may be varied depending on the account associated with the user and the permissions devolved thereto.

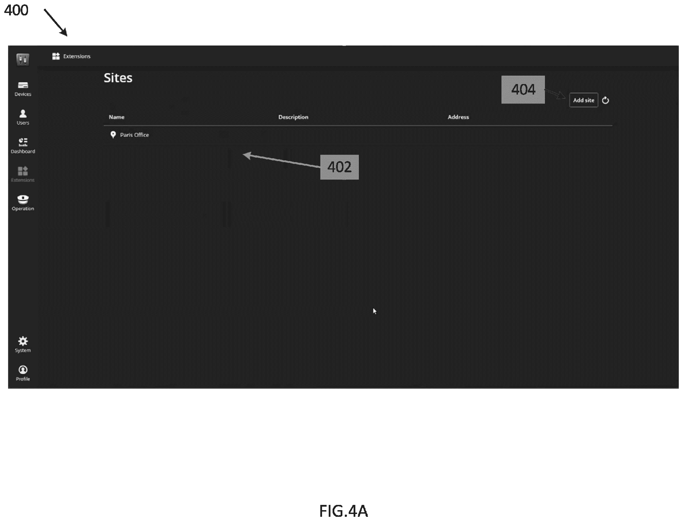

With additional reference to [Fig 4A], by selecting the Sites feature 302, the GUI 300 may transition to the GUI 400, illustrating a listing of sites 402 which the user is authorized to manage. Additionally, the GUI 400 may present one or more interactive elements. By interacting with the element 404, the user may be able to create a new site to be monitored within the physical security management system 200.

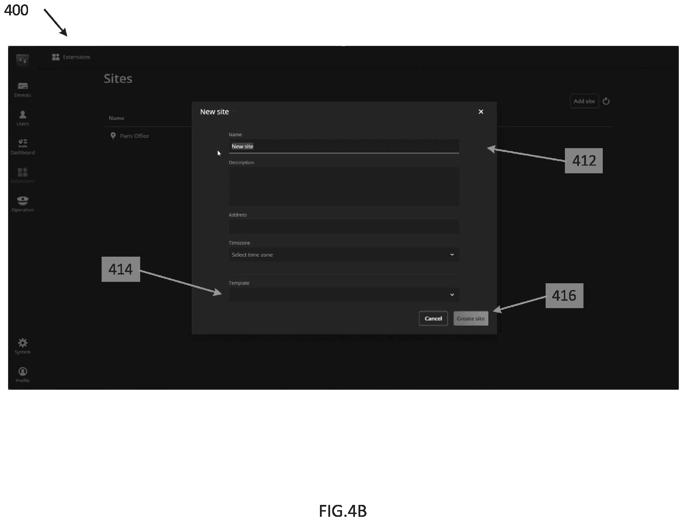

With additional reference to [Fig 4B], following interaction with the element 404, the GUI 400 may display a site information window 412 which accepts various input from a user. For example, a user may specify a name for the new site to be monitored, a description of the new site, an address and time zone, and other information, as appropriate. Once the appropriate information has been entered, the user may interact with element 416 to confirm the information. The physical security management system 200 may obtain the information provided by the user and generate a new site, which may be stored as part of the topology database 212, or in another database, as appropriate. In some embodiments, the creation of the site via window 412 may result in the generation of a new topological model, to be stored in the topology database 212. The topological model, as well as any ancillary or related information, may be stored in any suitable type of data structure within the topology database 212, as appropriate.

In some embodiments, the window 412 may allow a user to select a template site via the dropdown menu 414. Template sites are sites with a predetermined set of areas and optionally with a predetermined number of security devices. The relationship between the areas, as well as the locations of the security devices, may also be predetermined. Allowing a user to select a template may be convenient when a given user is managing multiple sites with similar or identical topological representations. For instance, a restaurant with multiple locations may establish a template having three areas (dining room, restrooms, kitchen) and a preset number of security devices (four cameras in the dining room, two cameras and two access control readers in the kitchen). Every time a new location opens, a user can create a new site via the element 404 and then select the appropriate template via the dropdown menu 414.

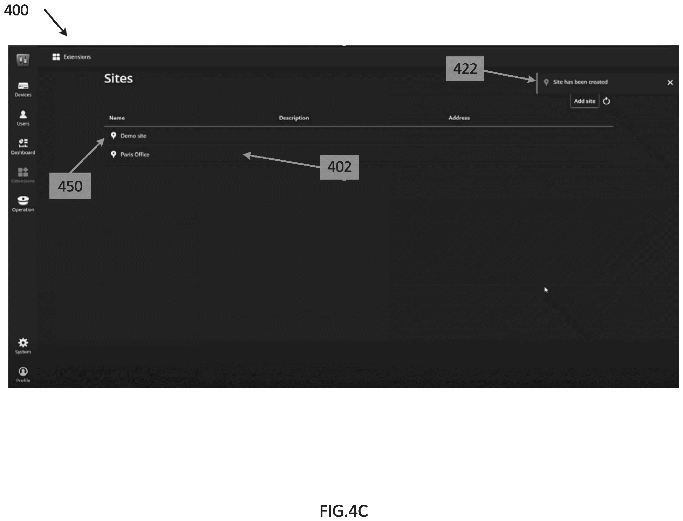

With additional reference to [Fig 4C], once a site is created, a confirmation message 422 can be displayed within the GUI 400, and the listing 402 can be updated to reflect the newly created site, in this case the site 450. The user may then interact with one of the sites in the listing, for instance the site 450, to see additional information about the site 450.

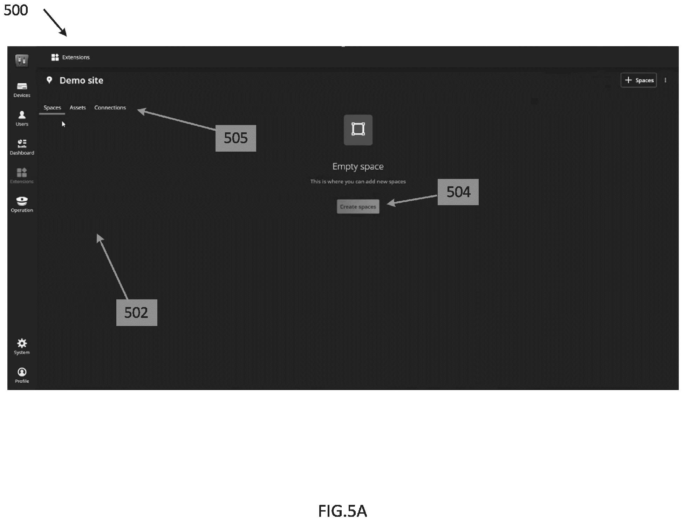

With reference to [Fig 5A], after interacting with one of the sites in the listing 402, the GUI 400 may transition to the GUI 500, illustrating additional information about the site 450. The GUI 500 may display a submenu 505, with one or more selectable elements for moving between different panes within the GUI 500. The GUI 500 may present, under the Spaces submenu, a listing 502 of existing areas, including the area names, type, relationships, and the like. The GUI 500 may also display an element 504 via which a user can create a new area, that is, a new area to be included as part of the topological model.

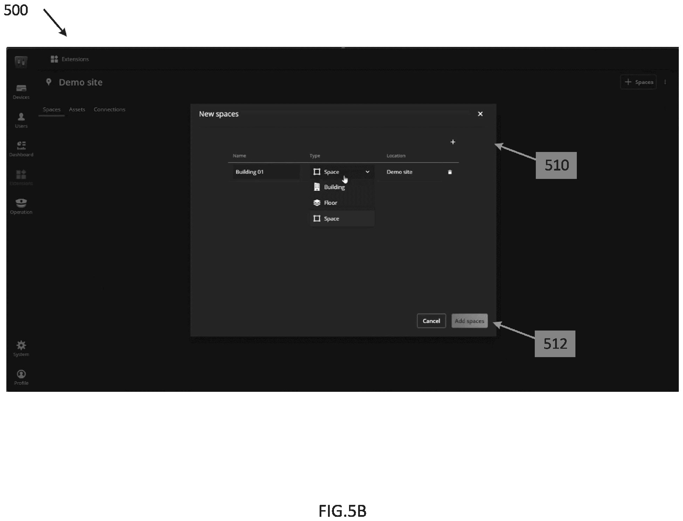

With additional reference to [Fig 5B], after obtaining an interaction with the element 504, the GUI 500 may present a window 510 via which user input relating to an area to be created can be obtained. The user input may specify a name of the area, a type of area, a location of the area (e.g., the site to which the area belongs), and the like. By interacting with the element 512, the user input may be transmitted to the physical security management system 200.

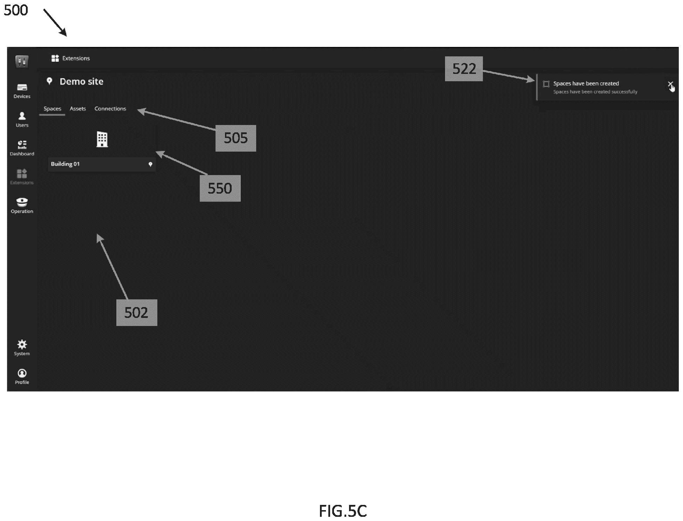

With additional reference to [Fig 5C], once the area is created, a confirmation message 522 can be displayed within the GUI 500, and the listing 502 can be updated to reflect the newly created area, this case the area 550. By interacting with the submenu 505, the GUI 500 may move to a different submenu and present different information associated with the site 450.

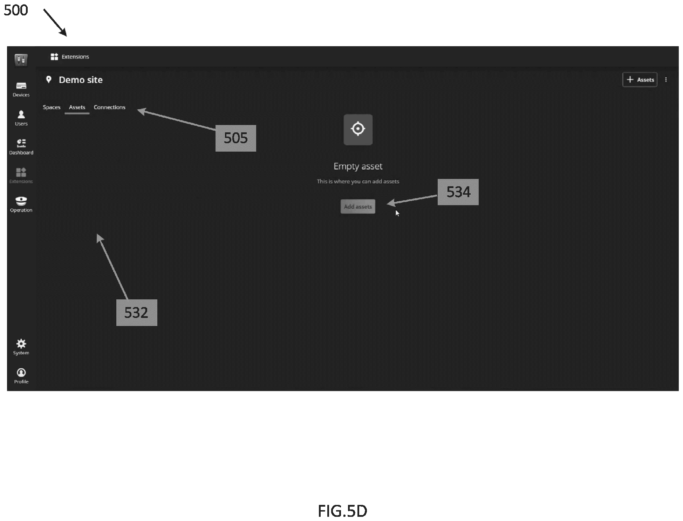

With additional reference to [Fig 5D], after obtaining an interaction with the submenu 505, the GUI 500 may move to the Assets submenu, where a listing 532 of security devices (termed "Assets" in the illustrated embodiments) associated with site 450 is presented, including the security device name, the security device type, the location of the security device (e.g., the area with which the security device is associated, and the like. The GUI 500 may also display an element 534 via which a user can create a new asset, that is, associate a new or existing security device with an area of the topological model.

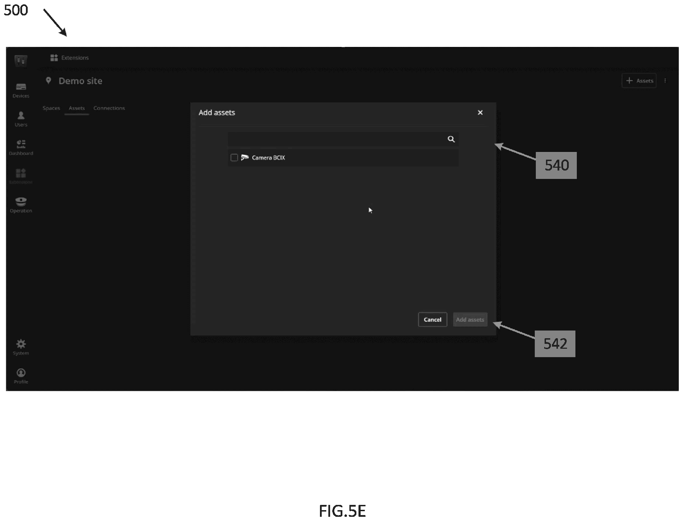

With additional reference to [Fig 5E], after obtaining an interaction with the element 534, the GUI 500 may present a window 540 via which user input relating to a security device to be associated with the site 450 can be obtained. The user input may specify a name of the security device, a type of security device, a location of the security device (e.g., the area within which the security device is located), and the like. By interacting with the element 542, the user input may be transmitted to the physical security management system 200. Once the user input is obtained, the listing 532 may be updated to reflect the newly associated security device.

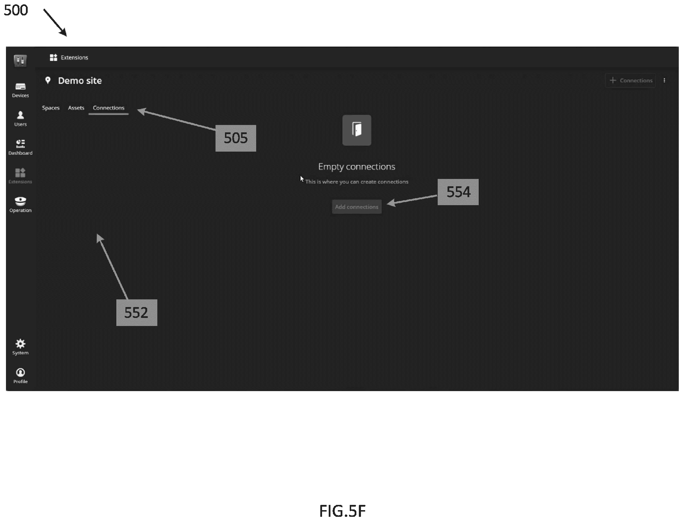

With additional reference to [Fig 5F], after obtaining an interaction with the submenu 505, the GUI 500 may move to the Connections submenu, where a listing 552 of relationships (termed "Connections" in the illustrated embodiments) between areas and/or security devices within the site 450 is presented, including names of the areas and/or security devices involved, the type of relationship, and the like. The GUI 500 may also display an element 554 via which a user can create a new relationship, that is, associate existing areas and/or security devices with one another.

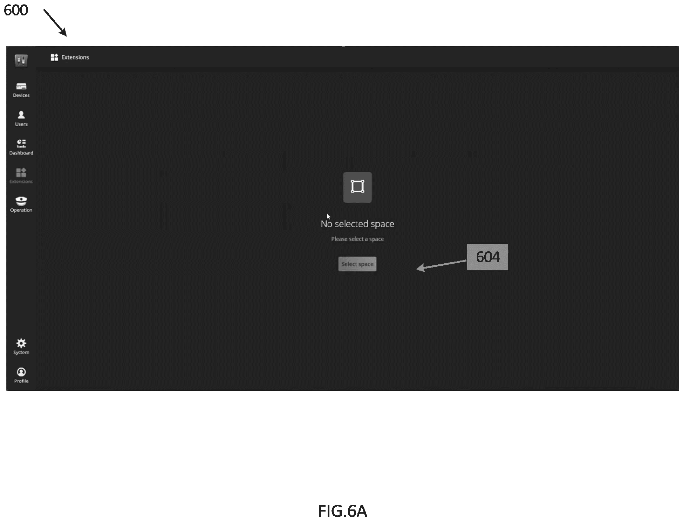

Returning to [Fig 3], and with additional reference to [Fig 6A], by selecting the Space Graph feature 304, the GUI 300 may transition to the GUI 600, presenting one or more interactive elements. By interacting with the element 604, the user may select one of the sites currently being monitored by the physical security management system 200.

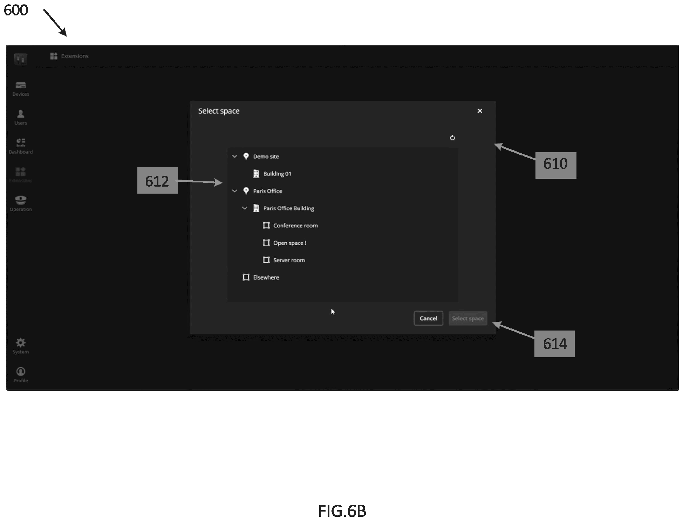

With additional reference to [Fig 6B], after obtaining an interaction with the element 604, the GUI 600 may present a window 610 via which user input relating to an area to be selected can be obtained. The user input may be obtaining in the listing 612 of the various areas forming part of the site 450, though if the user is authorized to monitor more than one site, the listing 612 may include more than one site. By interacting with the element 614 after performing a selection, the user input may be transmitted to the physical security management system 200.

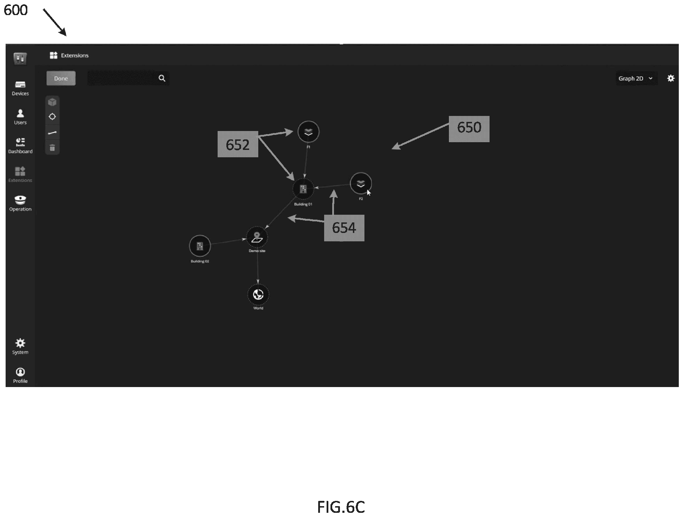

With additional reference to [Fig 6C], after obtaining an interaction with the element 614 to select an area, for example the site 450, the GUI 600 may present a visualization 650 of the topological model stored in the topology database 212; in other words, the visualization 650 is a visual representation of the site 450. In some embodiments, the visualization 650 resembles a tree diagram, composed of a plurality of nodes 652 connected by branches 654, though other types of visualizations are also considered. The nodes 652 represent different areas, different security devices, and the like, and the branches 654 represent the relationships therebetween. User input may be obtained to reposition the visualization 650, or parts thereof: for example, user input in the form of a click-and-drag or similar can be used to move a single one of the nodes to a particular location within the GUI 600. Other adjustments to the visualization 650, such as rotation, transposition, reflection (flipping), and the like are also considered.

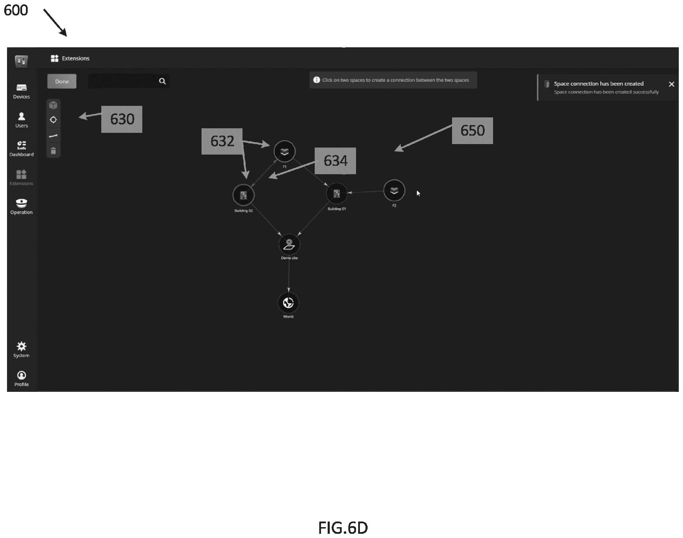

With reference to [Fig 6D], user input may be obtained via the GUI 600 to update the topological model. For instance, user input may be obtained via the menu 630 indicative of selection of a Connections tool, which allows the user to provide user input indicative of a relationship to be created in the topological model. By selecting two nodes, for instance the nodes 632, a relationship 634 between the two nodes can be created. The user input can be provided to the topology management engine 216 to effect an appropriate update to the topological model. Once the topological model is updated, the visualization 650 can be updated to reflect the changes, and reposition the nodes 652 to faithfully represent the topological model.

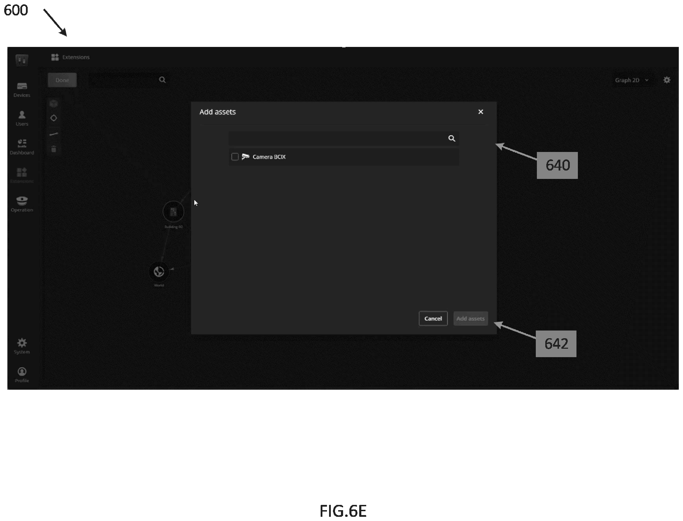

With reference to [Fig 6E], by way of another example, user input may be obtained via the menu 630 indicative of selection of an Assets tool, which allows the user to provide user input indicative of a security device to be associated with the topological model. When the Assets tool is selected, a window 640 may be presented via which user input relating to a security device to be associated with the site 450 can be obtained. The user input may specify a name of the security device, a type of security device, a location of the security device (e.g., the area within which the security device is located), and the like. By interacting with the element 642, the user input may be transmitted to the physical security management system 200. Once the user input is obtained, the topological model may be updated to reflect the newly associated security device.

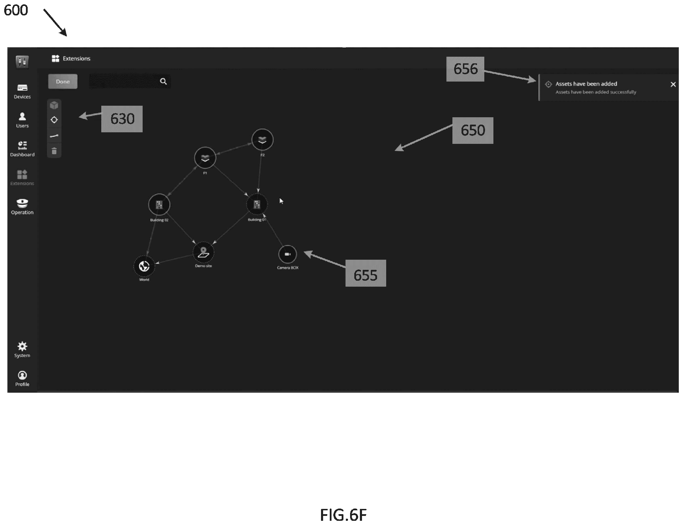

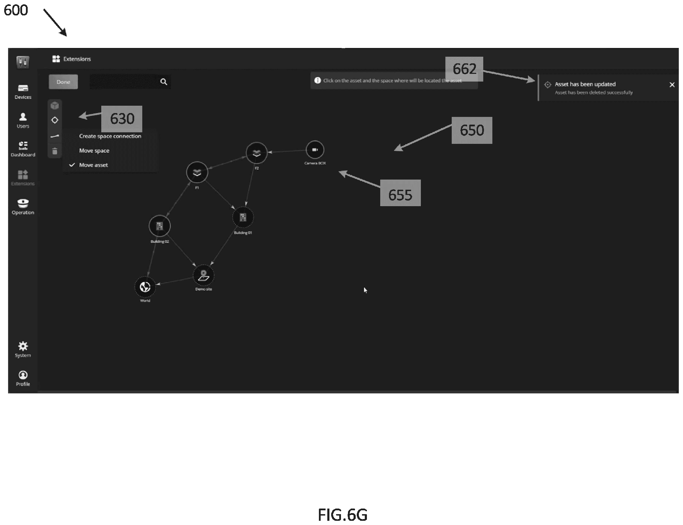

For example, and with additional reference to [Fig 6F], when user input indicative of a camera 655 is obtained via the window 640, a confirmation message 656 can be displayed within the GUI 600. Additionally, the visualization 650 can be updated to include a new node representing the camera 655, and a new relationship between the camera 655 and an associated area can be illustrated by an appropriate branch. Thus, the visualization 650 can be dynamically updated to reflect changes in the topological model, including the addition/removal of areas, the addition/removal of relationships between areas, and the association/disassociation of areas and security devices. By way of another example, and with additional reference to [Fig 6G], user input can be obtained indicative of disassociation of the camera 655 with a first area and association of the camera 655 with a second, different area. When this user input is obtained, the topology management engine may process the user input, update the topological model, and cause the visualization 650 to be updated to reflect the new association for the camera 655, and additionally cause a confirmation message 662 to be displayed.

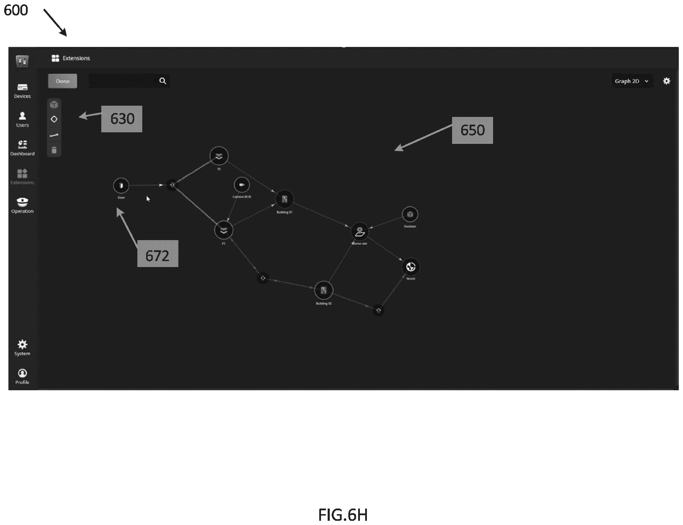

With reference to [Fig 6H], the visualization 650 may also be modified to explicitly show certain types of relationships. For example, in cases in which a relationship between two areas is a closed relationship, for instance two areas separated by a door 672, a togglable setting of the visualization 650 may be changed to hide or show the existence of the door 672. Other approaches for collapsing parts of the visualization 650, of filtering the visualization 650 for certain types of areas or security devices, and the like, are also considered.

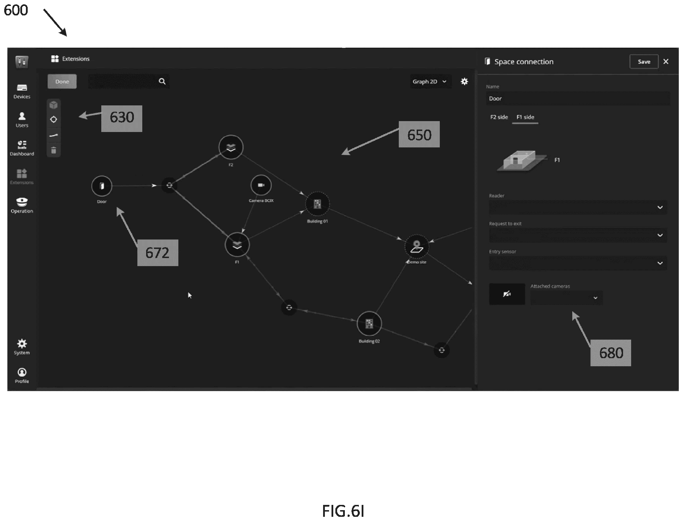

With additional reference to [Fig 6I], user input may also be obtained indicative of a desire to alter the configuration of a security device displayed in the visualization 650. For instance, by selecting a particular element in the menu 630, a configuration pane 680 for the door 672 may be caused to be displayed. Via the configuration page 680, additional user input indicative of configuration parameters for the door 672, or for security devices associated therewith, can be obtained. For instance, in the illustrated example, the configuration pane 680 illustrates two toggleable submenus for different sides of the door, and illustrates fields for obtaining input relating to an access card reader, a request to exit sensor, and an entry sensor for each side of the door, as well as a field for obtaining an indication of one or more cameras associated with the door 672. Other embodiments in which the configuration pane 680 may be configured for obtaining different information are also considered.

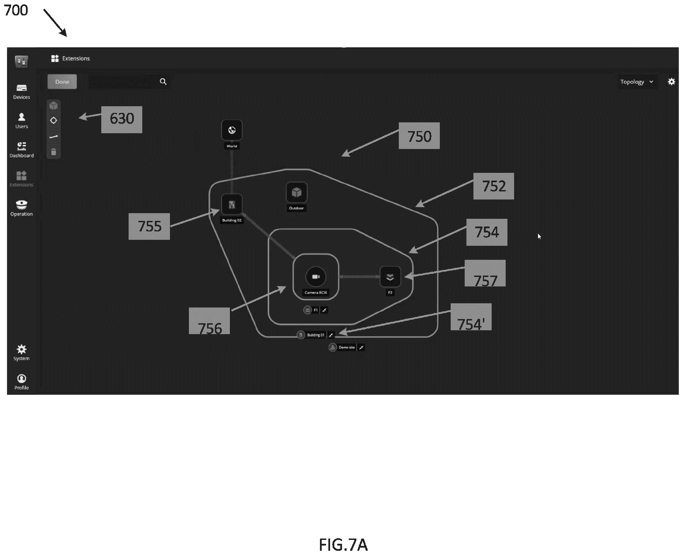

With reference to [Fig 7A], there is illustrated a GUI 700 which presents a visualization 750 of the topological model stored in the topology database 212; in other words, the visualization 750 is an alternative visualization to the visualization 650, and is also a visual representation of the site 450. In the illustrated embodiment, the visualization 750 indicates that the topological model is a hierarchical topological model, as different ones of the visual representations of the topological areas are nested within visual representations of other ones of the topological areas. In this particular visualization 750, the topological model is presented as a cellular diagram, composed of a plurality of nested cellular elements 752, 754, and 756. Within each cellular element, one or more areas, security devices, or other elements are displayed. In this fashion, the visualization 750 serves to illustrate the hierarchical relationship between various areas.

In this example, cellular element 752 is representative of a first-level geographical construct, in this case a site named "Demo site", to which belongs two second-level (i.e., lower-level) geographical constructs: a first building, "Building 01", represented by the cellular element 754 and the icon 754' and a second building, "Building 02", represented by the icon 755. The cellular element 754 may be used to represent Building 01 because Building 01 is also hierarchically associated with a further lower-level geographical construct, in this case floors "F1" and "F2". Floor F1 is represented by cellular element 756 because it, too, is hierarchically associated with a lower-level element, in this case a security device "Camera BCIX", which belongs to the floor F1; floor F2, for its part, is represented by the icon 757. In this fashion, the visualization 750 can be used to visually represent the hierarchical relationships between the various areas, which are of various levels. Although this example presents four levels (site, building, floor, space/device), it should be understood that further levels are also considered. Various user input may be provided by a user to establish the hierarchical relationships between different geographical constructs, as appropriate.

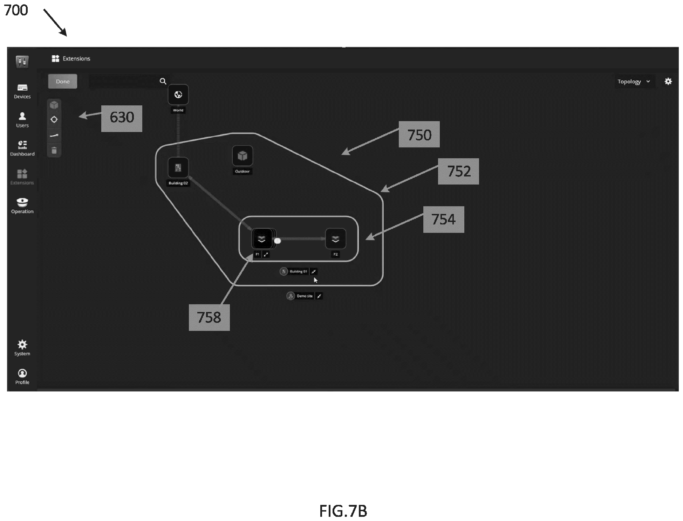

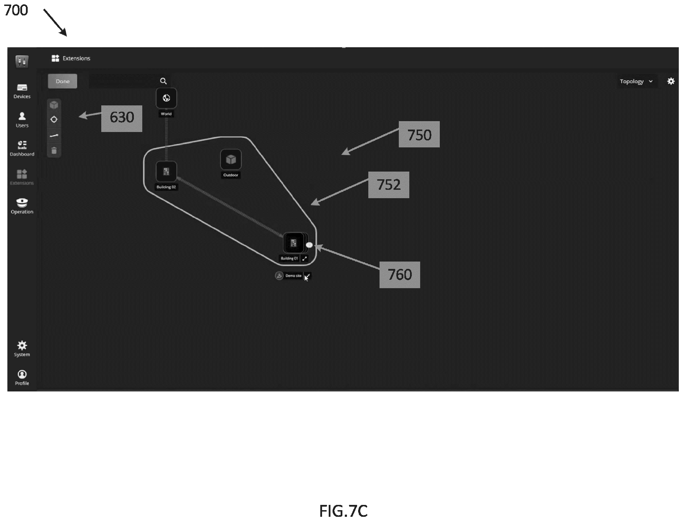

With additional reference to [Fig 7B], the cellular elements within the visualization 750 can be collapsed. For instance, by interacting with an element of the menu 630, or with part of the cellular element 756, the cellular element 756 can be collapsed into a stacked icon 758. Similarly, with additional reference to [Fig 7C], by interacting with an element of the menu 630, or with part of the cellular element 754, the cellular element 754 can be collapsed into a stacked icon 760.

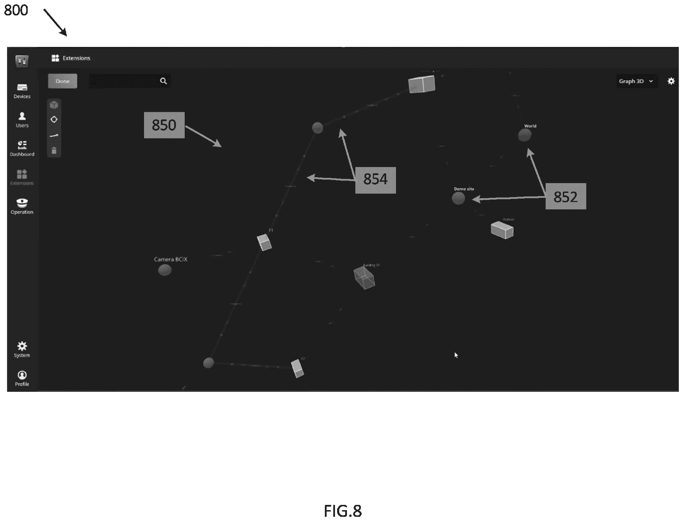

With additional reference to [Fig 8], there is illustrated a GUI 800 which presents a visualization 850 of the topological model stored in the topology database 212; in other words, the visualization 850 is an alternative visualization to the visualizations 650 and 750, and is also a visual representation of the site 450. In the illustrated embodiment, the visualization 850 resembles a three-dimensional diagram, composed of a plurality of three-dimensional objects 852 connected by branches 854. The visualization 850 can be moved, rotated, flipped, etc., by way of user input. In this fashion, the visualization 850 serves to illustrate the relationship between various areas

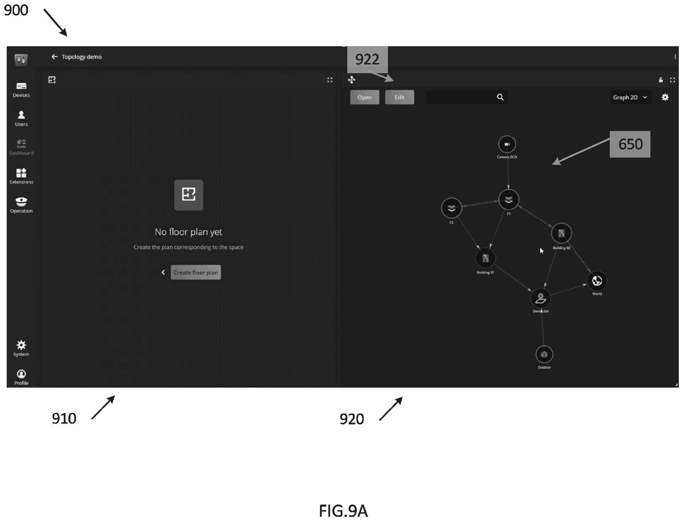

With reference to [Fig 9A], there is illustrated a GUI 900 which presents first and second panes 910, 920. In the second pane 920, the visualization 650 is displayed. The second pane 920 also displays various menus 922 via which the visualization 650 may be modified, altered, or the like. The first pane 910 displays an element 912 via which a user can select a floor plan to associate with one or more of the areas displayed in the visualization 650, that is to say, with one or more of the areas forming part of the site 450. The division of the GUI 900 into the first and second panes 910, 920 may be customizable. For example, one of the first and second panes 910, 920 may be collapsable, or the proportion of the GUI 900 allocated to the first and second panes 910, 920 may be varied, for instance in response to user input.

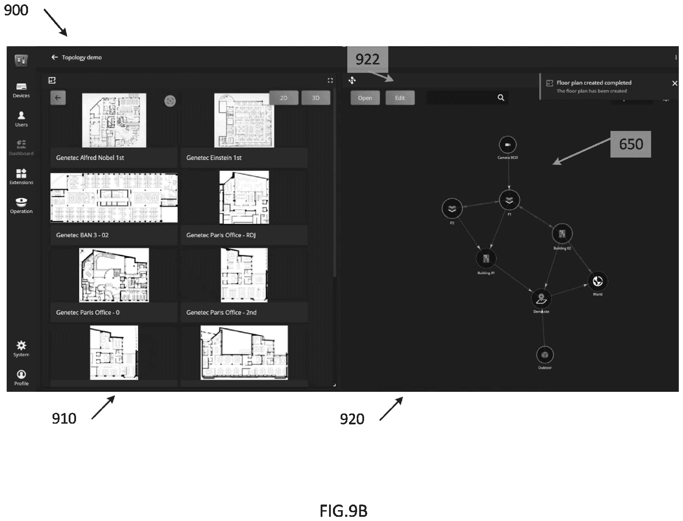

With additional reference to [Fig 9B], after obtaining an interaction with the element 912, the first pane 910 of the GUI 900 may be updated to present a listing of floor plans 914, which may be acquired by a map representation component accessing stored map data, which may be stored within the security server 110 or externally thereto. The floor plans may be image files (e.g., JPEG or PNG images), document files (e.g., PDF files), topology files (e.g., GML files), or the like. The GUI 900 may be configured to obtain user input regarding selection of one of the floor plans in the listing 914: by interacting with the element 512, the user input indicating a selected floor plan 950 may be transmitted to the physical security management system 200. For example, the topology management engine 216 may be configured for interpreting the user input to associate the selected floor plan 950 with one or more areas present in the visualization 650. In some cases, the GUI 900 obtains user input in the second pane 920 indicative of a selected area, and the selected floor plan 950 from the listing 914 may be associated with the selected area. In some other cases, the topology management engine 216 may determine, based on the nature of the visualization 650 and/or the size, scope, or nature of the selected floor plan 950, the area within the topological model with which to associate the floor plan 950.

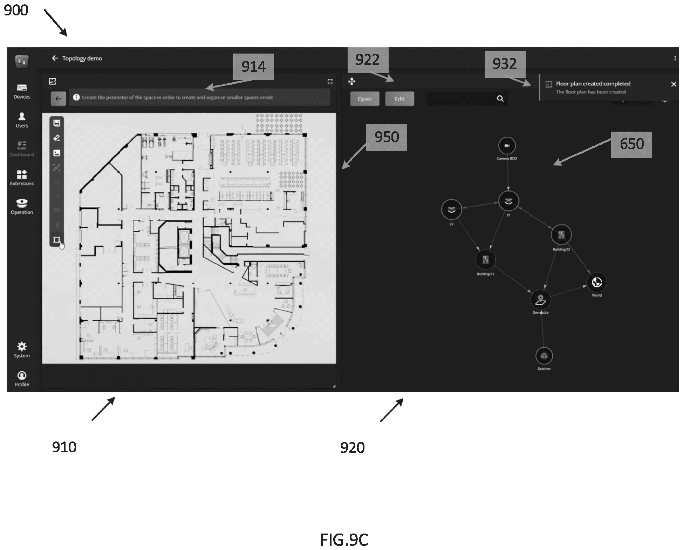

With additional reference to [Fig 9C], once the floor plan 950 is associated with the one or more areas of the topological model, a confirmation message 932 can be displayed within the GUI 900 In addition, the first pane 910 displays the floor plan 950 which was associated with the one or more areas presented in the second pane 920. The floor plan 950 may be interactive, as described in greater detail hereinbelow, for instance to move, rotate, etc., the floor plan 950, display elements of the topological model and/or of the site 450 within the floor plan 950, and the like. For example, user input may be obtained for associating the various areas of the topological model within the floor plan 950, for defining geographical portions of the site 450 within the floor plan 950, and the like. To this end, the GUI 900 may display a prompt 914 to the user to solicit further user input to define areas within the floor plan 950.

In this fashion, the first pane 910 can present, via the floor plan 950, map data which defines spatial attributes of one or more topological areas within the site, whilst the second pane 920 presents, via the visualization 650, logical connectivity relationships between the topological areas within the site. This may facilitate understanding of the layout of the site, the physical and logical relationships between the various topological areas defining the site, and the like.

In some embodiments, various image analysis techniques may be performed on the floor plan 950 to derive therefrom information about the topological areas defining the site. For instance, various techniques including edge detection, image recognition, optical character recognition, and the like may be employed to interpret the floor plan 950 and identify different spaces, floors, buildings, and/or sites. The security server 110 may then, for instance responsive to user input within the GUI 900, modify the topological model to include the topological areas identified from the floor plan 950. In some embodiments, the security server 110 may propose an interpretation of the floor plan 950 and solicit user input confirming or modifying the interpretation, for instance via the GUI 900.

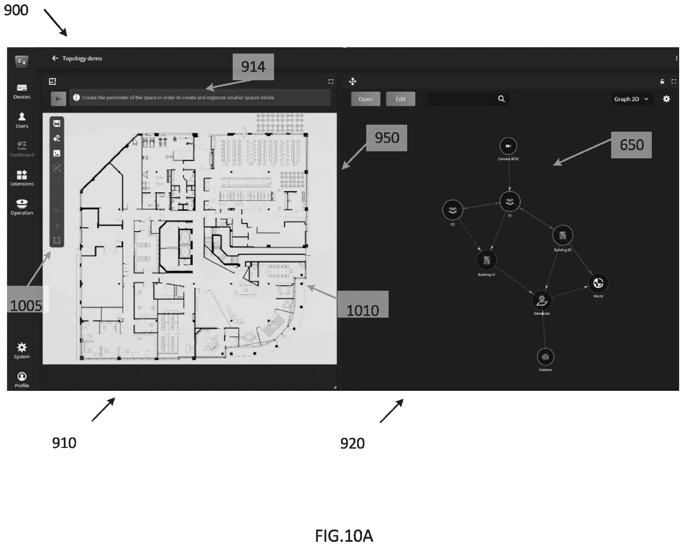

With additional reference to [Fig 10A], the GUI 900 may present a menu 1005 with one or more selectable elements, each providing different functionality by which the user may provide user input for defining elements of the topological model and/or positioning the security devices 120 within the floor plan 950. In the embodiment illustrated in [Fig 10A], in response to the prompt 914, a perimeter input tool is selected and user input is provided to define a perimeter 1010 for the floor plan 950. The perimeter 1010 may be defined by the user providing a series of points, by the user tracing the perimeter 1010 by clicking and dragging a mouse or other pointing device, or the like. Alternatively, an edge detection or similar image processing technique may be used to determine the perimeter 1010 automatically, without further user input, or to present a detected perimeter 1010 to the user for soliciting approval or modification therefrom. Other approaches for determining the perimeter 1010 of the floor plan 950 are also considered. In some embodiments, once the perimeter 1010 is determined, the region of the floor plan 950 enclosed by the perimeter 1010 may be, by default, associated with a particular area, for example a highest-level area in a hierarchical topological model, a predetermined area (e.g., a particular building, floor, or space), or the like. In some embodiments, the user may be prompted to select a particular area within the site 450 via the visualization 650, or in some other fashion, with which to associate the area enclosed by the perimeter 1010.

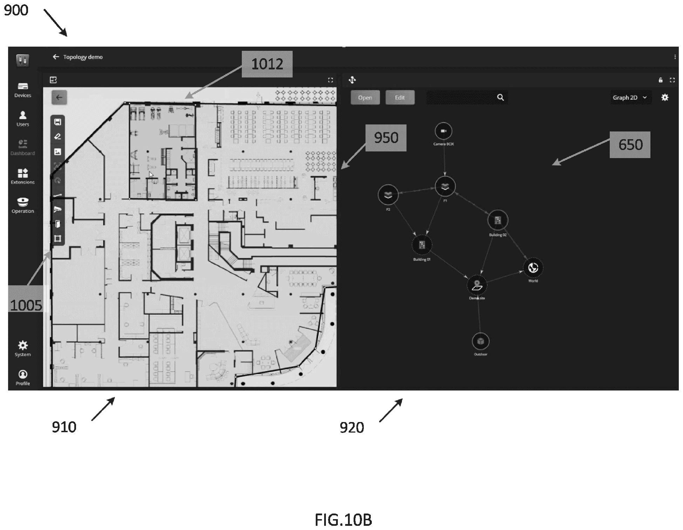

With reference to [Fig 10B], an area definition tool is selected from the menu 1005 and user input is provided to define an area 1012 within the floor plan 950. The area 1012 may be defined by the user providing a series of points, by the user tracing an outline of the area 1012 by clicking and dragging a mouse or other pointing device, or the like. Alternatively, an edge detection or similar image processing technique may be used to automatically determine the one or more areas 1012 contained within the perimeter 1010, without further user input, or to present a set of detected areas 1012 to the user for soliciting approval or modification therefrom. For instance, by looking at the walls or other delimitations within the floor plan 950, an edge detection algorithm can identify all the different areas 1012 contained within the perimeter 1010. Other approaches for determining the location of various areas 1012 within the floor plan 950 are also considered. In some embodiments, the user may be prompted to select a particular area within the site 450 via the visualization 650, or in some other fashion, with which to associate the newly defined area 1012 In some other embodiments, the area 1012, once created, remains unassigned to any area of the topological model until further user input is obtained, for instance via a menu or the like. Any number of areas 1012 can be created within the floor plan 950, for instance by repeatedly outlining different areas 1012, by repeating automated area detection algorithms, or the like.

Any areas 1012 that are disposed adjoining to one another may be inferred, for instance by the topology management engine 216, to share a relationship (e.g., to be connected by a door, a hallway, or the like). These relationships may be stored in the topology database 212, for instance within the topological model, or may be maintained elsewhere by the topology management engine 216 until the relevant areas 1012 are associated with areas of the topological model, at which time the associations between the areas 1012 may also be represented within the topological model by creating relationships between the associated areas.

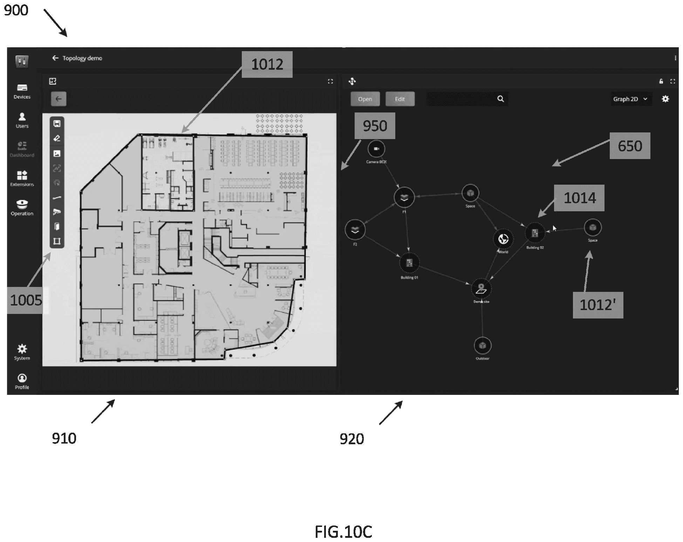

With additional reference to [Fig 10C], when the area 1012 is created, it is then replicated within the topological model, and thus displayed as part of the visualization 650, shown here as node 1012'. As a result of the newly-created area, the rest of the visualization 650 may rearrange itself, for instance to better fit within the second pane 920. In addition, as the area 1012 is within the perimeter 1010 of the floor plan 950, a relationship is created between the area 1012 and the area associated with the floor plan 950, in this case Building 02, illustrated at 1014. If the area 1012 is later associated with one of the areas that were already part of the topological model, then the newly-created area within the topological model may be deleted, and node 1012' may disappear from the visualization 650; additionally, any relationships between the node 1012 may be reassigned to the existing area and, if any conflicting relationships are identified (e.g., self-referential relationships), they may be removed, or an error message may be presented to the user.

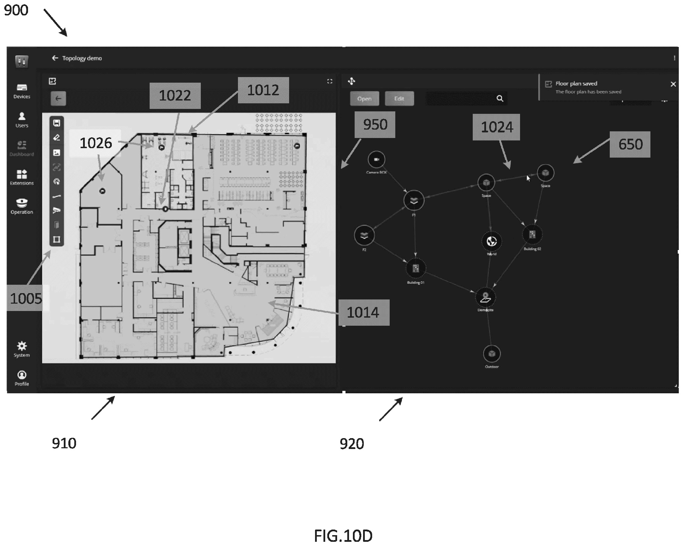

With reference to [Fig 10D], relationships between areas may also be explicitly created via a relationship definition tool, which may be selected from the menu 1005. For example, user input may be obtained which identifies two areas; a relationship between those two areas may then be created within the topological model by the topology management engine 216. The relationship between the two areas may be a closed relationship (i.e., some barrier to traversing from one area to another exists) or an open relationship (i.e., no barrier to traversing from one area to another exists). In the illustrated example of [Fig 10D], the relationship between area 1012 and area 1014 may be a closed relationship, and thus illustrated by a door icon 1022. Other icons may be used to illustrate closed relationships, for instance based on the nature of the barrier between areas (e.g., a gate, a turnstile, etc.). Open relationships may be represented by other icons (e.g., a hallway, an open doorway, etc.). When the relationship is created, it is then replicated within the topological model, and thus displayed as part of the visualization 650, shown here by way of the branch 1024. As a result of the newly-created relationship, the rest of the visualization 650 may rearrange itself, for instance to better fit within the second pane 920.

In addition, the location of the security devices 120 within the site 450 may be provided by way of user input using a security device localization tool from the menu 1005. For example, user input may be obtained which identifies the location of a security device. The GUI 900 may present a listing of the security devices 120, via which subsequent user input identifying one of the security devices 120 can be obtained. In this fashion, the location of the selected security device 120 can be set as the identified location. When a security device 120 is localized within the floor plan 950, it may be identified by way of a suitable icon, for instance the camera icons 1026 for cameras, an access control reader icon for access control devices, and the like.

The process of creating areas 1012 via the floor plan 950, of creating relationships between the areas, and the like, can be repeated as many times as appropriate, in response to further user input. Areas created within the GUI 900 via floor plan 950 can be associated with existing areas within the topological model, for instance areas defined via the GUI 500, by way of suitable user input. When setting up the topological model for a new site, the process may begin by creating areas and relationships within the GUI 900 via the floor plan 950, by creating areas and relationships via the GUI 500, or both, as appropriate. In addition, the association of security devices with the various areas defined in the topological model can be done via the GUI 500, within the GUI 900 via the floor plan 950, or both, as appropriate.

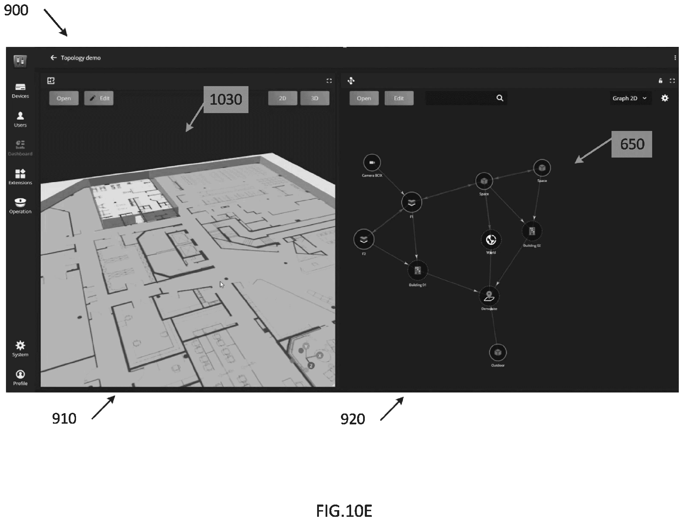

With reference to [Fig 10E], the GUI 900 may be configured for displaying a three-dimensional rendering 1030 of the floor plan 950. The three-dimensional rendering 1030 may be produced by extruding the perimeter 1010 and the outlines of the areas 1020 defined within the floor plan 950, or by any other suitable approach. The three-dimensional rendering 1030 may be configured for being repositioned, rotated, flipped, etc., by way of suitable user input. In some embodiments, the security devices 120 may be displayed within the three-dimensional rendering 1030.

With reference to [Fig 11], an alternative GUI 1100 for generating a site is illustrated. The GUI 1100 contains a text chat pane 1102 via which user input in the form of freeform text can be obtained. The freeform text may then be interpreted by a large-language model (LLM) or similar text-processing algorithm to determine the nature of requests provided by the user in the user input. The requests may then be interpreted to identify areas, relationships between areas, security devices, and the like, to be integrated into a topological model. In some embodiments, the LLM is configured for interpreting the user input and generating instructions suitable for providing to an Application Program Interface (API) employed by, for instance, the topology management engine 216 of the physical security management system 200. The topology management engine 216 can then create or update the topological model based on the API instructions received thereby. In response to generation of the topological model, a visualization 1150 may be displayed in a separate pane of the GUI 1100. Generation of the topological model via user input to the text chat pane 1102 may be repeated to continue to generate areas, relationships, and the like. The visualization 1150 may be interacted with via user input, for instance to translate, rotate, reflect, etc., the visualization 1150.

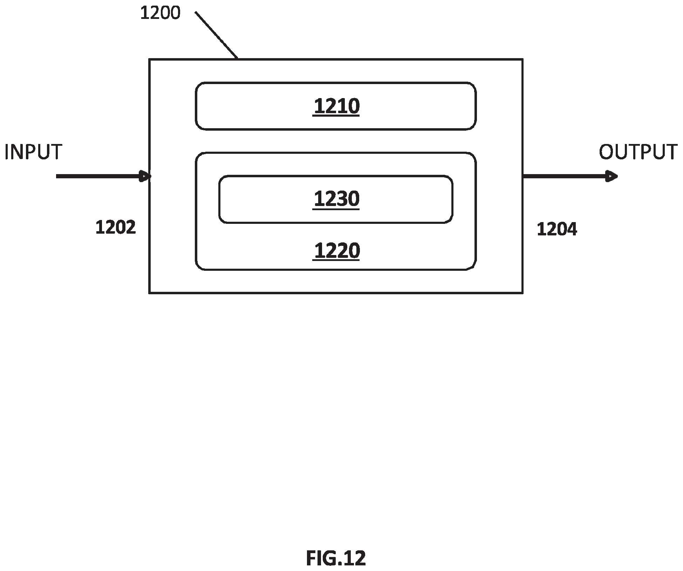

With reference to [Fig 12], there is illustrated a schematic diagram of an example computing device 1200. As depicted, the computing device 1200 includes at least one processor 1210, a memory 1220, and program instructions 1230 stored within the memory 1220, as well as input and output interfaces (I/O interfaces) 1202 and 1204, respectively. For simplicity, only one computing device 1200 is shown; the various computing devices described herein may be embodied by one or more implementations of the computing device 1200, which may be the same or different types of devices. The components of the computing device 1200 may be connected in various ways including directly coupled, indirectly coupled via a network, and distributed over a wide geographic area and connected via a network, for instance via a cloud computing implementation.

The I/O interfaces 1202, 1204 may include one or more media interfaces, via which removable media or other data sources may be coupled, one or more network interfaces, or any other suitable type of interface. The I/O interfaces 1202, 1204 of the computing device 1200 may additionally, in some embodiments, provide interconnection functionality to one or more input devices, such as a keyboard, mouse, camera, touch screen and a microphone, or with one or more output devices such as a display screen and a speaker, for instance devices via which a user may interact with a server. In embodiments in which the I/O interfaces 1202, 1204 include one or more network interfaces, the network interface(s) of the computing device 1200 may enable the computing device 1200 to communicate with other components, to exchange data with other components, to access and connect to network resources, to serve applications, and perform other computing applications by connecting to a network (or multiple networks) capable of carrying data including the Internet, Ethernet, plain old telephone service (POTS) line, public switch telephone network (PSTN), integrated services digital network (ISDN), digital subscriber line (DSL), coaxial cable, fiber optics, satellite, mobile, wireless (e.g. Wi-Fi, WiMAX), SS7 signaling network, fixed line, local area network, wide area network, and others, including any combination of these.

The processor 1210 may be, for example, any type of general-purpose microprocessor or microcontroller, a digital signal processing (DSP) processor, an integrated circuit, a field programmable gate array (FPGA), a reconfigurable processor, a programmable read-only memory (PROM), or any combination thereof. The processor 1210 may be configured for executing the instructions 1230 stored within the memory 1220. The memory 1220 may include a suitable combination of any type of computer memory that is located either internally or externally such as, for example, random-access memory (RAM), read-only memory (ROM), compact disc read-only memory (CDROM), electro-optical memory, magneto-optical memory, erasable programmable read-only memory (EPROM), and electrically erasable programmable read-only memory (EEPROM), Ferroelectric RAM (FRAM) or the like.

In certain embodiments, the computing device 1200 is operable to register and authenticate users (using a login, unique identifier, and password for example) prior to providing access to applications, a local network, network resources, other networks, and network security devices. The computing device 1200 may serve one user or multiple users.

For example, and without limitation, the computing device 1200 may be a server, network appliance, set-top box, embedded device, computer expansion module, personal computer, laptop, personal data assistant, cellular telephone, smartphone device, UMPC tablets, video display terminal, gaming console, electronic reading device, and wireless hypermedia device or any other computing device capable of being configured to carry out the methods and/or implementing the systems described herein.

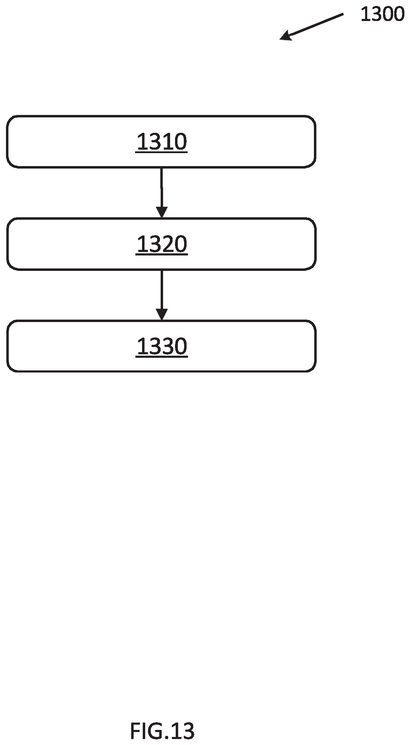

With reference to [Fig 13], there is illustrated a flowchart for a method 1300 for establishing a topological model for a site being monitored by a plurality of security devices. At 1310, first user input defining a first topological area and a relationship between the first topological area and at least one second topological area of the topological model is obtained. At 1320, the first user input is interpreted to update the topological model to represent the first topological area and the relationship between the first topological area and the at least one second topological area. At 1330, a display device is caused to display at least part of the topological model following said updating thereof.

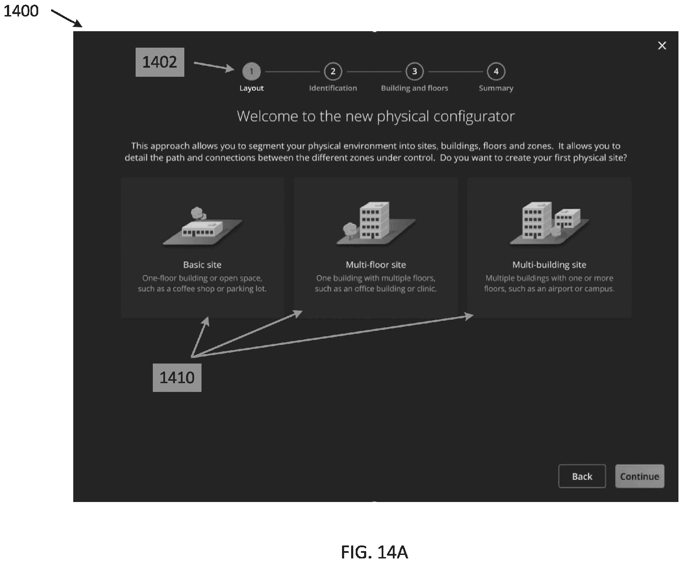

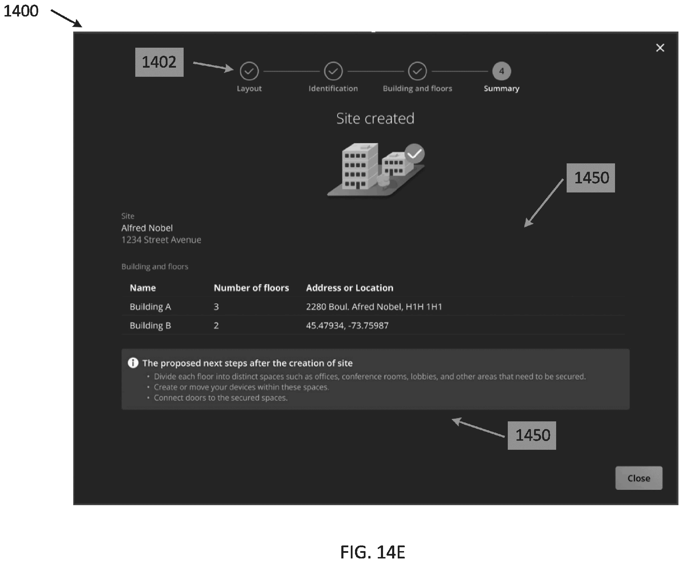

With reference to [Fig 14A] to [Fig 14E], in some embodiments, the physical security management system 200 may present a configuration wizard 1400 to facilitate the configuration of the site. The configuration wizard 1400 is composed of a plurality of pages through which the configuration wizard 1400 progresses in response to user input provided by a user. In some embodiments, the configuration wizard 1400 may progress automatically in response to user input indicative of configuration parameters for the site. In some other embodiments, the configuration wizard 1400 comprises one or more GUI elements via which the user can provide user input to cause the configuration wizard 1400 to progress from one page to the next. The configuration wizard 1400 can also include an index 1402 which indicates the number of pages contained in the configuration wizard 1400. In some implementations, including the example of [Fig 14A] to [Fig 14E], one GUI element of the index 1402 may be highlighted or otherwise varied relative to the other GUI elements to indicate a current page from amongst the plurality of pages.

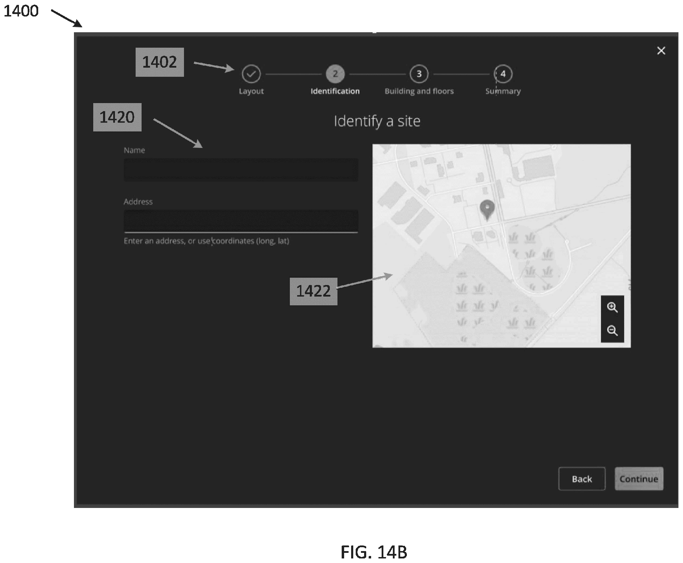

In [Fig 14A], the configuration wizard 1400 presents a first page to solicit user input relating to a layout of the site. In this example, the configuration wizard 1400 presents three potential layouts 1410, though it should be understood that in other examples, other potential layouts may apply. In this example, the potential layouts 1410 include a basic site, a multi-floor site, and a multi-building site. The GUI elements illustrating potential layouts 1410 may also include a short textual description of the different potential layouts 1410. When the user selects one of the potential layouts, or interacts with a Continue GUI element in the configuration wizard 1400, the configuration wizard 1400 may progress from [Fig 14A] to [Fig 14B].

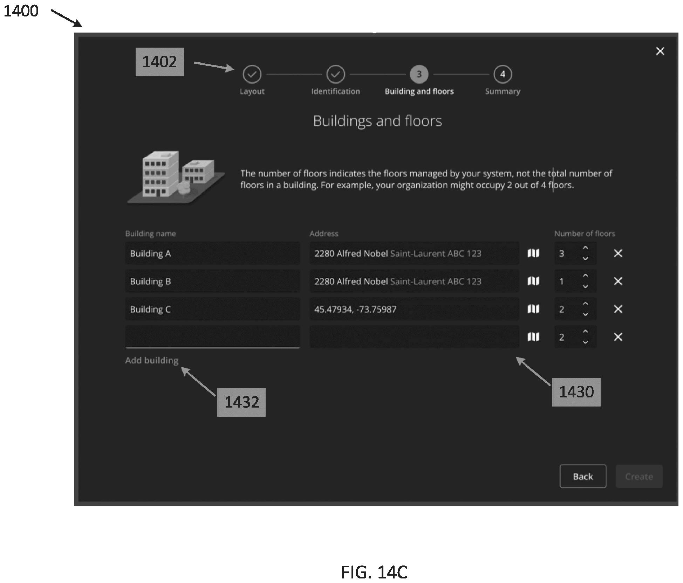

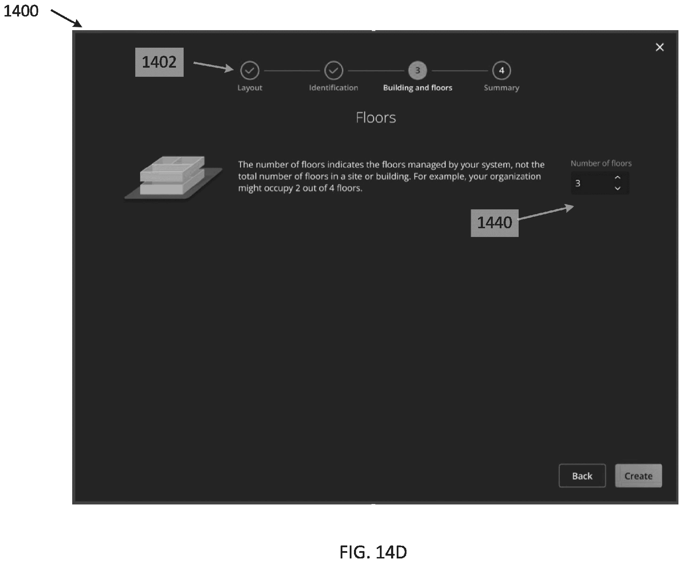

In [Figure 14B], the configuration wizard 1400 presents a second page to solicit user input to identify the site. The configuration wizard 1400 may present one or more user input fields 1420 via which user input indicative of a name and a location of the site can be provided. Additionally, or in the alternative, the configuration wizard 1400 can present a map view 1422 via which user input indicative of a location of the site can be provided. In some embodiments, when user input is provided via one of the user input fields 1420, the map view 1422 can be updated to illustrate the location indicated by the user input; similarly, if user input is provided via the map view 1422, the user input fields 1420 can be updated to indicate a geolocation, address, or the like which corresponds to the location indicated by the user input. When the user provides user input indicative of the location of the site, or interacts with a Continue GUI element in the configuration wizard 1400, the configuration wizard 1400 may progress from [Fig 14B] to [Fig 14C] or [Fig 14D], depending on the type of layout identified by the user input provided via the configuration wizard 1400 in [Fig 14A].

In [Fig 14C], when the user has selected the multi-building site layout 1410, the configuration wizard 1400 presents a third page to solicit user input regarding names, locations, and floor count for the various buildings in the site via user input fields 1430. Additionally, the configuration wizard 1400 can present a GUI element 1432 via which the user can indicate that an additional building should be added to the site. The user input fields 1430 may accept textual input, present one or more dropdown menus, autocomplete certain input, for instance based on a database of allowable addresses, allow numerical input for floor counts, including via increment buttons, and the like. When the user provides user input indicative of the names, locations, and floor counts for the various buildings in the site, or interacts with a Continue GUI element in the configuration wizard 1400, the configuration wizard 1400 may progress from [Fig 14C] to [Fig 14E].

In [Fig 14D], when the user has selected the multi-floor site layout 1410, the configuration wizard 1400 presents an alternative third page to solicit user input regarding the floor count for the building in the site via user input fields 1440. The user input fields 1440 may accept numerical input for floor count, including via increment buttons, and the like. In some embodiments, a user may also provide an indication of the types of connections between floors, such as a number of stairwells, a number of elevators, and the like. When the user provides user input indicative of the floor count for the building in the site, or interacts with a Continue GUI element in the configuration wizard 1400, the configuration wizard 1400 may progress from [F14D] to [Fig 14E].

In cases in which the user has selected the basic layout 1410 as part of the first page of the configuration wizard 1400, the configuration wizard may present a further alternative third page to solicit user input, or may skip the third page and proceed directly from the second page to the fourth page, illustrated in [Fig 14E].

In [Fig 14E], the configuration wizard 1400 presents a fourth page to present confirmatory information 1450 to the user. The confirmatory information may be varied based on the user input provided by the user as part of [Fig 14A] to [Fig 14D], including the name and location of the site, the names and locations of the various buildings, the floor count of the various buildings, and the like. In some implementations, the confirmatory information may additionally present other useful information, including best practices, tips, suggested next steps, and the like. The configuration wizard 1400 may then be closed by a user by interacting with a Close GUI element.

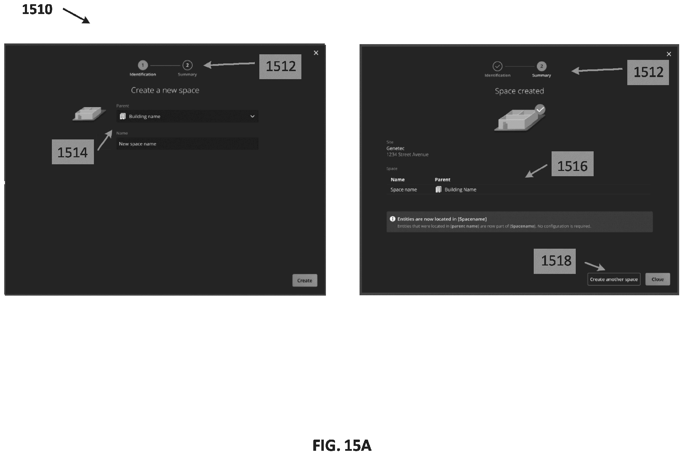

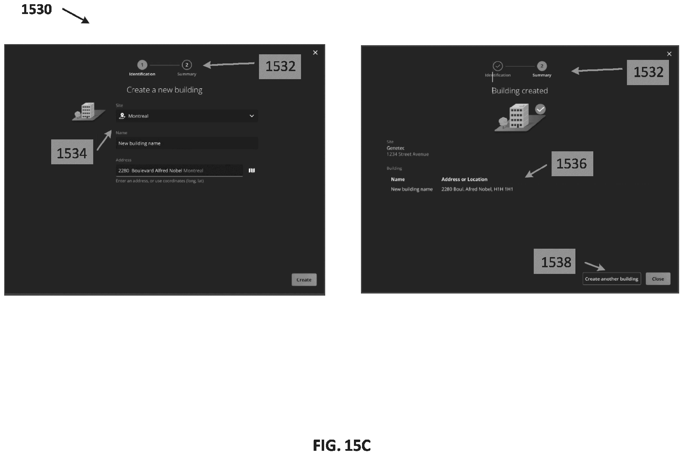

With reference to [Fig 15A] to [Fig 15C], in some embodiments, the physical security management system 200 may present one or more configuration wizards 1510, 1520, 1530 to facilitate the configuration of the site. Similarly to the configuration wizard 1400, the configuration wizards 1510, 1520, 1530 are composed of a plurality of pages through which the configuration wizard 1500 progresses in response to user input. In some embodiments, the configuration wizards 1510, 1520, 1530 may progress automatically in response to user input indicative of configuration parameters for the site. In some other embodiments, configuration wizards 1510, 1520, 1530 comprises one or more GUI elements via which the user can provide user input to cause configuration wizards 1510, 1520, 1530 to progress from one page to the next. The configuration wizards 1510, 1520, 1530 can also include respective indexes 1512, 1522, 1532 which indicates the number of pages contained in the configuration wizards 1510, 1520, 1530. In some implementations, including the examples of [Fig 15A] to [Fig 15C], one GUI element of the indexes 1512, 1522, 1532 may be highlighted or otherwise varied relative to the other GUI elements to indicate a current page from amongst the plurality of pages.

In [Fig 15A], the configuration wizard 1510 is illustrated. A first page of the configuration wizard 1510 allows the user to create a new space to be integrated into the topological model of the site. The configuration wizard 1510 presents, via the first page, user input fields 1514 via which the user can indicate the building and/or the floor to which the space to be created belongs. This may be used to create a hierarchical relationship between the to-be-created space and one or more existing topological areas. The user input fields 1514 may also accept user input indicative of a name of the space. When the user provides the solicited user input, or interacts with a Create GUI element in the configuration wizard 1510, the configuration wizard 1510 may progress to a second page which presents confirmatory information 1516 to the user. The confirmatory information may be varied based on the user input provided by the user as part of the first page of the configuration wizard 1510, including the name of the space and its relationship within the topological model. The configuration wizard 1510 may then be closed by a user by interacting with a Close GUI element or may be restarted by the user via an interaction with the Create another space user element 1518.

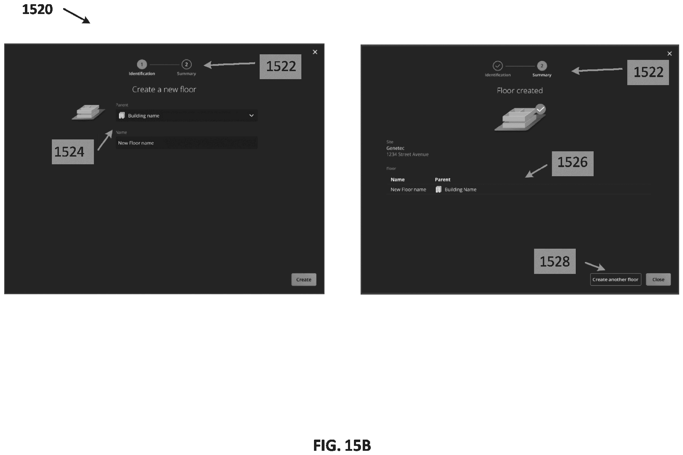

In [Fig 15B], the configuration wizard 1520 is illustrated. A first page of the configuration wizard 1520 allows the user to create a new floor to be integrated into the topological model of the site. The configuration wizard 1520 presents, via the first page, user input fields 1524 via which the user can indicate the building to which the floor to be created belongs, and in some cases a hierarchy of the floor within the building. This may be used to create a hierarchical relationship between the to-be-created floor and one or more existing topological areas. The user input fields 1524 may also accept user input indicative of a name of the floor. When the user provides the solicited user input, or interacts with a Create GUI element in the configuration wizard 1520, the configuration wizard 1520 may progress to a second page which presents confirmatory information 1526 to the user. The confirmatory information may be varied based on the user input provided by the user as part of the first page of the configuration wizard 1520, including the name of the floor and its relationship within the topological model. The configuration wizard 1520 may then be closed by a user by interacting with a Close GUI element or may be restarted by the user via an interaction with the Create another floor user element 1528.

In [Fig 15C], the configuration wizard 1530 is illustrated. A first page of the configuration wizard 1530 allows the user to create a new building to be integrated into the topological model of the site. The configuration wizard 1530 presents, via the first page, user input fields 1534 via which the user can indicate the site to which the building should be added and an address or other location of the building. The user input fields 1534 may also accept user input indicative of a name of the building. When the user provides the solicited user input, or interacts with a Continue GUI element in the configuration wizard 1530, the configuration wizard 1530 may progress to a second page which presents confirmatory information 1536 to the user. The confirmatory information may be varied based on the user input provided by the user as part of the first page of the configuration wizard 1530, including the name of the floor and its relationship within the topological model. The configuration wizard 1530 may then be closed by a user by interacting with a Close GUI element or may be restarted by the user via an interaction with the Create another building user element 1538.

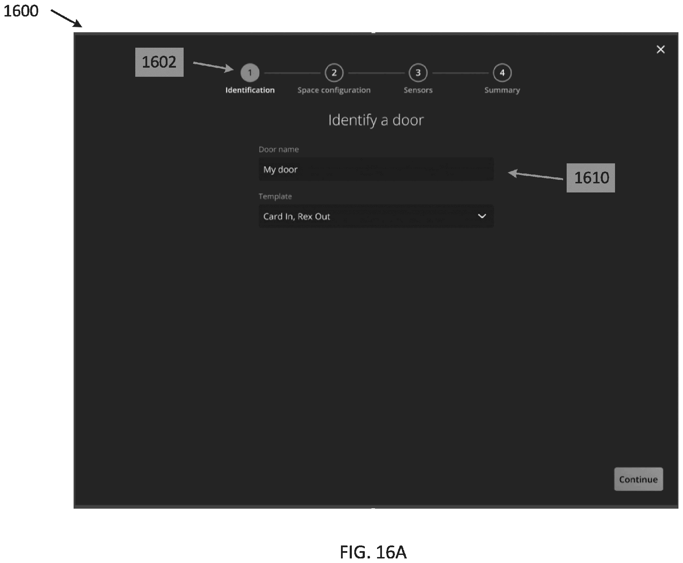

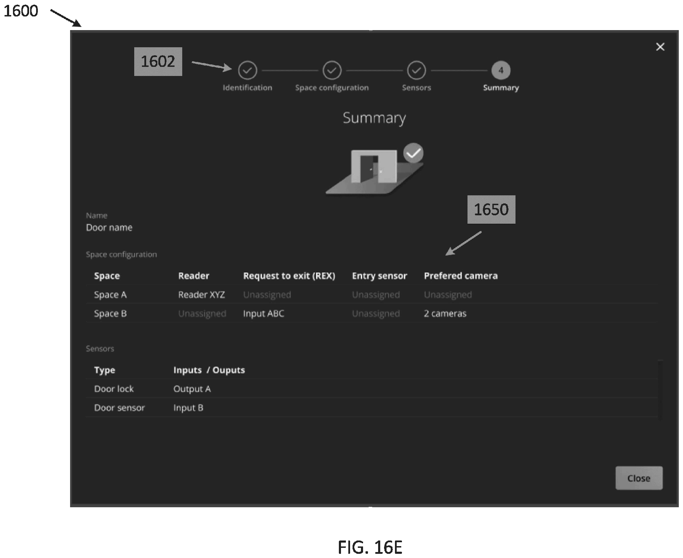

With reference to [Fig 16A] to [Fig 16E], in some embodiments, the physical security management system 200 may present a configuration wizard 1600 to facilitate the configuration of the site. The configuration wizard 1600 is composed of a plurality of pages through which the configuration wizard 1600 progresses in response to user input provided by a user. In some embodiments, the configuration wizard 1600 may progress automatically in response to user input indicative of configuration parameters for the site. In some other embodiments, the configuration wizard 1600 comprises one or more GUI elements via which the user can provide user input to cause the configuration wizard 1600 to progress from one page to the next. The configuration wizard 1600 can also include an index 1602 which indicates the number of pages contained in the configuration wizard 1600. In some implementations, including the example of [Fig 16A] to [Fig 16E], one GUI element of the index 1602 may be highlighted or otherwise varied relative to the other GUI elements to indicate a current page from amongst the plurality of pages.

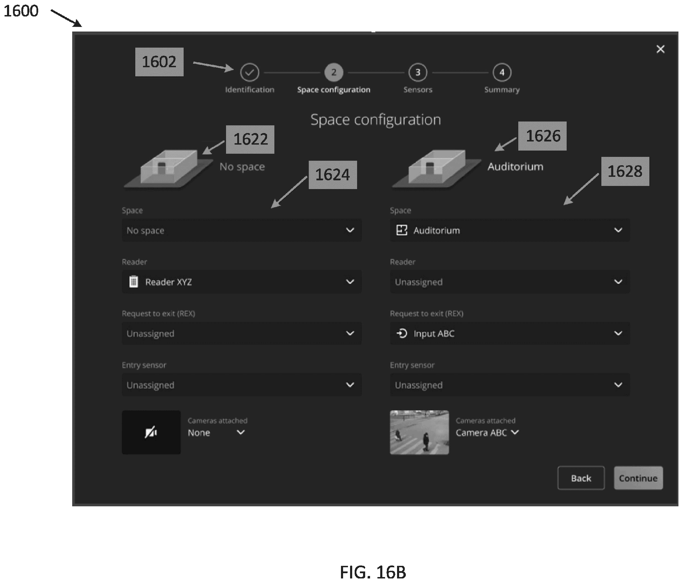

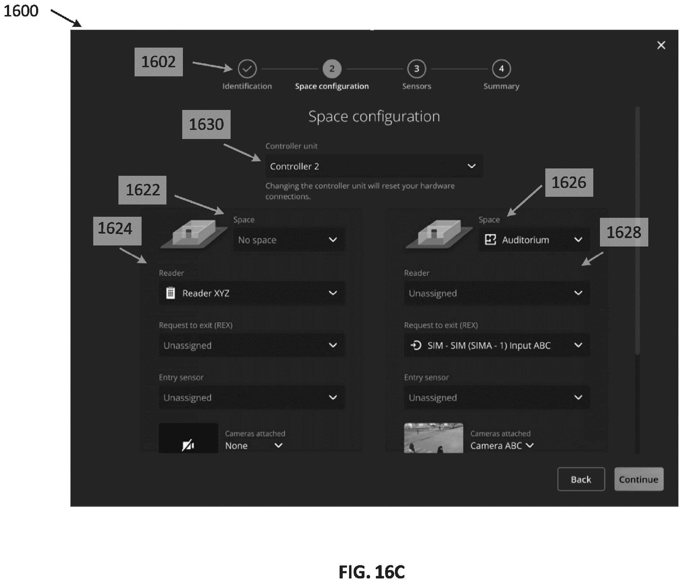

In [Fig 16A], the configuration wizard 1600 presents a first page to solicit user input relating to a relationship between two spaces in the topological model. In this example, the nature of the relationship between the two spaces is indicated as a "door", and the configuration wizard 1600 presents user input fields 1610 via which a user can indicate a name for the door and optionally select a template to apply to the door. The selection of a template may vary the information presented as part of one or more subsequent pages, including prepopulating certain user input fields based on the template selected. It should be understood that the configuration wizard 1600 may also be used for other type of relationships, including turnstiles, corridors, stairs, elevators, and the like. The template user input field 1610 may allow a user to select, for instance from a dropdown menu, one of a plurality of configuration templates to apply for the door being configured. When the user provides user input indicative of the relationship to be configured, or interacts with a Continue GUI element in the configuration wizard 1600, the configuration wizard 1600 may progress from [Fig 16A] to [Fig 16B] or [Fig 16C], depending on the configuration of the site, on user preference, on the type of security devices already included as part of the physical security management system 200, or the like.

In [Fig 16B], the configuration wizard 1600 presents a second page to solicit user input relating to configuring the relationship between the two spaces of the topological model identified via [Fig 16A] of the configuration wizard 1600. The configuration wizard 1600 presents a visual representation of the first space 1622 and the second space 1626, with the door (or other transition point) located therebetween. To further illustrate the relationship between the spaces, the first space 1622 is highlighted relative to the second space within the portion of the second page associated with the configuration of the first space side of the relationship, and the second space 1626 is highlighted relative to the first space within the portion of the second page associated with the configuration of the second space side of the relationship.

The portion of the second page associated with the first space side of the relationship includes a plurality of user input fields 1624 via which user input relating to the configuration of the first space side of the relationship can be provided by a user. This can include a user field to indicate the space in question, which may be selected by way of a dropdown menu, entered via textual input, which may autocomplete to a list of existing spaces, or the like. The user input fields 1624 also include one or more fields to indicate security devices to be associated with the first space side of the relationship, including an access card reader, a request to exist (REX) sensor, an entry sensor, a camera, and the like. User input in form of textual input, for instance with autocomplete to a list of existing security devices, selection via a dropdown menu, and the like, may be obtained via the user input fields 1624.

Similarly, the portion of the second page associated with the second space side of the relationship includes a plurality of user input fields 1628 via which user input relating to the configuration of the second space side of the relationship can be provided by a user. This can include a user field to indicate the space in question, which may be selected by way of a dropdown menu, entered via textual input, which may autocomplete to a list of existing spaces, or the like. The user input fields 1628 also include one or more fields to indicate security devices to be associated with the second space side of the relationship, including an access card reader, a request to exist (REX) sensor, an entry sensor, a camera, and the like. User input in form of textual input, for instance with autocomplete to a list of existing security devices, selection via a dropdown menu, and the like, may be obtained via the user input fields 1624.

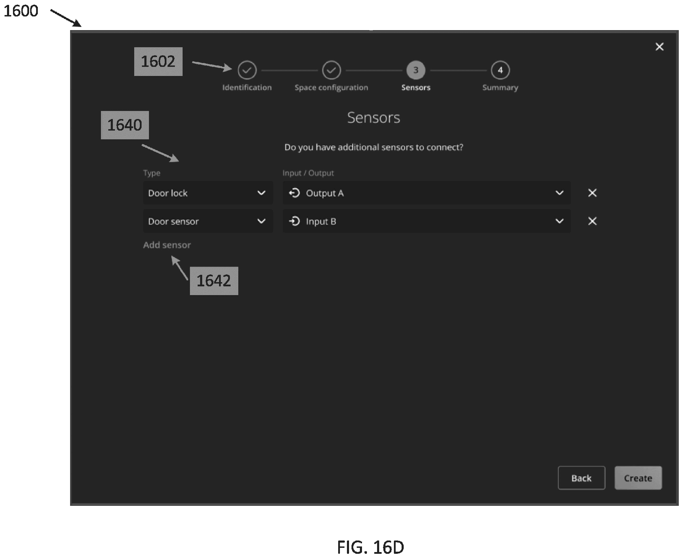

When the user provides user input indicative of the security devices to associate with the relationship, or interacts with a Continue GUI element in the configuration wizard 1600, the configuration wizard 1600 may progress from [Fig 16B] to [Fig 16D].

In [Fig 16C], the configuration wizard 1600 presents a variation second page to solicit user input relating to configuring the relationship between the two spaces of the topological model identified via [Fig 16A] of the configuration wizard 1600. The variant second page illustrated in [Fig 16C] additionally includes a user input field 1630 via which a user can provide user input indicative of a controller unit to be associated with the relationship between the first space and the second space. The user input field 1630 may receive user input by way of a dropdown menu, textual input, which may autocomplete to a list of existing spaces, or the like. When the user provides user input indicative of the controller unit to associate with the relationship, or interacts with a Continue GUI element in the configuration wizard 1600, the configuration wizard 1600 may progress from [Fig 16C] to [Fig 16D].

In [Fig 16D], the configuration wizard 1600 presents a third page to solicit user input relating to associating further security devices with the relationship between the two spaces of the topological model identified via [Fig 16A] of the configuration wizard 1600. The configuration wizard 1600 may present one or more user input fields 1640 via which user input indicative of one or more security devices, or sensors, to be associated with the relationship can be provided. The security devices associated with the relationship via the input fields 1640 may be security devices which are associated with both sides of the relationship, rather than with only one side, as with the security devices indicated via the input fields 1624 and 1628. Additionally, the configuration wizard 1600 can present a GUI element 1642 via which the user can indicate that an additional input field 1640 should be displayed to allow for an additional security device to be associated with the relationship. The user input fields 1640 may receive user input by way of a dropdown menu, textual input, which may autocomplete to a list of existing spaces, or the like. The user input fields 1640 may also obtain input indicative of whether the security devices are providing input data, or are to be provided with output data, as appropriate. When the user provides user input indicative of the security devices to be associated with the relationship, or interacts with a Continue GUI element in the configuration wizard 1600, the configuration wizard 1600 may progress from [Fig 16D] to [Fig 16E].

In [Fig 16E], the configuration wizard 1600 presents a fourth page to present confirmatory information 1650 to the user. The confirmatory information may be varied based on the user input provided by the user as part of [Fig 16A] to [Fig 16D], including the name and type of security devices, as well as their association, with the relationship and/or different sides thereof, and the like. The configuration wizard 1400 may then be closed by a user by interacting with a Close GUI element.

The user input provided via the configuration wizards 1400, 1510, 1520, 1530, 1600 can be used by the topology management engine to update the topological model, as described elsewhere herein. For instance, user input provided via the configuration wizard 1400 may be used by the topology management engine to instantiate the topological model based on the layout indicated by the user input provided via the potential layouts 1410, to update the topological model to represent the various buildings, floors, and spaces indicated via the configuration wizard 1400, to keep records of the names, locations, and the like of the various areas composing the topological model, and the like. Similarly, user input provided via the configuration wizards 1510, 1520, 1530, 1600 may be used to update the topological model to add buildings, floors, and/or spaces, to associated various security devices with different areas or with relationships therebetween, and the like.

Although the configuration wizards 1400, 1510, 1520, 1530, 1600 have been presented as separate wizards, it should be understood that any of the configuration wizards may be composed of any number of pages, such that the pages of one configuration wizard can be included in another one of the configuration wizards, as appropriate. Additionally, pages from one configuration wizard can be included in another configuration wizard, and the order of pages in the configuration wizards 1400, 1510, 1520, 1530, 1600 can be varied, as appropriate.

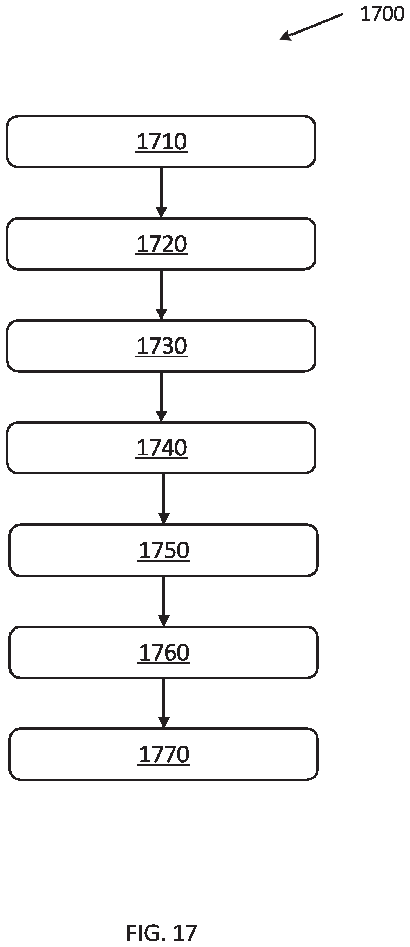

With reference to [Fig 17], there is illustrated a flowchart for a method 1700 for configuring a physical security management system. At 1710, a graphical user interface for receiving user input is displayed, the graphical user interface configured to progress through a plurality of pages soliciting user input relating to a site being monitored. At 1720, first user input indicative of a layout of the site is obtained via a first page of the plurality of pages; the layout may be a high-level description of the format or shape of the site being monitored and/or the operational context for the site. At 1730, a topological model of the site being monitored representative of the layout is generated, based on the first user input. At 1740, second user input indicative of one or more topological areas within the site being monitored is obtained via a second page of the plurality of pages. At 1750, one or more constituent elements representative of the one or more topological areas are generated within the topological model of the site being monitored, based on the second user input. At 1760, third user input indicative of an association of at least one physical security device with a respective one of the one or more constituent elements is obtained via a third page of the plurality of pages. In certain embodiments, a given security device may only be allowed to be associated with a single space. At 1770, the at least one physical security device is assigned, based on the third user input, to the respective one of the one or more constituent elements within the topological model of the site being monitored. It should be understood that the various steps of the method 1700 may be performed in any suitable order. For instance, steps 1760 and 1770 may be performed before steps 1740 and 1750. By way of another example, steps 1720, 1740, and 1760 may be performed prior to performing steps 1730, 1750, and 1770.

In some embodiments, the method 1700 may additionally include displaying an index to indicate a current page and/or the plurality of pages within the graphical user interface. In some embodiments, the second user input is indicative of a number of buildings composing the site, of a number of floors composing a building of the site, of a number of spaces composing a floor of a building of the site, or the like, and the generation of the one or more constituent elements is varies on the basis of the user input. In some embodiments, the method 1700 may additionally include obtaining, via a fourth page, fourth user input indicative of a relationship between first and second spaces of the site, and generating a representation of the relationship based on the fourth user input. In some cases, the fourth user input is indicative of a security device mediating the relationship between the first and second spaces, and an association between the security device and the relationship may be generated based on the fourth user input. In some cases, the fourth user input is indicative of a side of the relationship which the security device mediates, and generating the association comprises associating the security device with one of the first and second space, depending on the fourth user input. The security device may be an access control device.

In some embodiments, the method 1700 may additionally include obtaining, via a fourth page, fourth user input indicative of a location of the site and associating the topological model with the location. The location may be a georeferenced location, a civic address, or the like. In some embodiments, the method 1700 may additionally include presenting, via a confirmation page, confirmation information relating to at last some of the first, second, third, and optionally fourth user input. In some implementations, the confirmation page may additionally present other useful information, including best practices, tips, suggested next steps, and the like.

The topological model generated via the method 1700 may include a graph structure composed of nodes and edges, as described elsewhere herein. Thus, generating the constituent elements for the topological areas may include generating a root node as a first constituent element, representative of the site or of a first space within the site, and generating additional nodes, for instance leaf nodes, as further constituent elements of the site, which may be linked to the root node by one or more edges, as appropriate.

In some embodiments, the method 1700 also includes accessing map data defining a map of the site, for instance based on the location provided by fourth user input. The map data defines one or more spatial attributes for the site, and is distinct from the topological mode. The map data may be displayed, in whole or in part, as a map within a graphical user interface, for instance in conjunction with a visual representation of the topological model, as described elsewhere herein. In some cases, additional user input may be obtained to establish a relationship between one or more constituent elements of the topological model and different portions of the map, which may be cause the constituent elements to be associated with the respective map portions, as indicated by the user input.
1. According to some embodiments, a physical security management system for securing a site monitored by security devices. The security management system comprises a topology database storing a topological model of the site; a network interface adapted for obtaining security data from the security devices; an input interface adapted for obtaining first user input from an input device defining first topological area and a relationship between the first topological area and at least one second topological area; a topology management engine coupled to the topological database, the topology management engine adapted for interpreting the first user input to configure the topological model to represent the first topological area and the relationship between the first topological area and the at least one second topological area; and an output interface adapted for causing display, via the display device, of at least part of the topological model following said updating thereof.
2. The security management system according to clause 1, wherein the input interface is adapted for obtaining additional user input indicative of a first security device being located within the first area; the topology management engine is adapted for interpreting the additional user input to create an association between the first area and the first security device; and the output interface is adapted for causing the display device to display a visual representation of the first security device in association with the first area.
3. The security management system according to clause 1 or clause 2, further comprising a configuration database storing configuration data associated with the security devices; a configuration management engine coupled to the configuration database, the configuration management engine adapted for interpreting additional user input to update the configuration data associated with the security devices; wherein the network interface is adapted for providing the configuration data to the security devices.
4. The security management system according to any of clauses 1-3, wherein the input interface is adapted for obtaining first relationship user input indicative of selection of a first relationship between a first pair of topological areas defined in the topological model; the input interface is adapted for obtaining second relationship user input indicative of a first security device being associated with the first relationship; the topology management engine is adapted for interpreting the first and second relationship user input to create an association between the first relationship and the first security device; and the output interface is adapted for causing the display device to display a visual representation of the first security device in association with the first relationship.
5. The security management system according to clause 4, wherein the second relationship user input is further indicative of a second security device being associated with the first relationship, and wherein the topology management engine is adapted for interpreting the second relationship user input to associate the first security device with a first side of the first relationship and to associate the second security device with a second side of the first relationship, the first and second sides being different.
6. The security management system according to clause 5, wherein the topological model comprises a graph structure composed of nodes representing areas and edges representing connections between areas, the first and second areas being a represented by a first and second node, respectively, in the topological model, and the first relationship is represented by an edge between the first and second node.
7. The security management system according to clause 6, wherein the graph structure is a unidirectional graph, wherein the first side of the first relationship is a first edge between the first and second node, and the second side of the first relationship is a second edge between the first and second node.
8. The security management system according to any of clauses 1-7, wherein the topological model comprises a graph structure composed of nodes representing areas and edges representing connections between areas, the first and second areas being a represented by a first node and a second node, respectively, in the topological model, and a particular relationship being represented by an edge between the first and second nodes.
9. The security management system according to clause 8, wherein the graph structure is a unidirectional graph.
10. The security management system according to clause 8 or clause 9, wherein the output interface is adapted for causing display, via the display device, of a visual representation of a particular security device associated with the relationship between the first topological area and the at least one second topological area as being associated with the edge between the first and second nodes.
11. The security management system according to any of clauses 8-10, wherein the input interface is adapted for obtaining third user input indicative of a selection of the edge between the first and second nodes, and wherein the output interface is adapted for, responsive to obtaining the third user input, causing display, via the display device, of relationship configuration parameters associated with the relationship between the first and second topological areas.
12. The security management system according to any of clauses 1-11, wherein the topological model is a hierarchical topological model, the topology management engine being adapted for creating hierarchical relationships between first level geographical constructs and second level geographical constructs belonging to the first level geographical constructs, the input interface adapted for obtaining third user input defining a hierarchical relationship between a particular first level geographical construct and a particular second level geographical construct belonging to the particular first level geographical construct.
13. The security management system according to clause 12, wherein the third user input defines the particular first level geographical construct and defines the first area as the particular second level geographical construct.
14. The security management system according to clause 13, wherein the third user input further defines the second area as another second level geographical construct belonging to the particular first level geographical construct.
15. The security management system according to clause 13 or clause 14, wherein the output interface is adapted for causing display, via the display device, of the hierarchical topological model, comprising displaying a visual representation of first area as being nested within a visual representation of the particular first level geographical construct.
16. The security management system according to any of clauses 1-15, further comprising a map representation component adapted for accessing stored map data and representing the map data as a map on the display device via the output interface, the map data being distinct from the topological model and defining spatial attributes of the site, the topological model defining logical connectivity relationships for the site.
17. The security management system according to clause 16, further comprising processing map data to automatically derive therefrom the first topological area and the second topological area and the relationship between the first topological area and the second topological area.
18. The security management system according to any of clauses 1-17, wherein the input interface is adapted for obtaining further user input indicative of at least one of a subsequent topological area and a relationship between the subsequent topological area and at least one existing topological area, wherein the topology management engine is adapted for interpreting the further user input and further updating the topological model to represent the subsequent topological area and the relationship between the subsequent topological area and the at least one existing topological area, and wherein the output interface is adapted for causing display of the at least part of the topological mode, including the subsequent topological area, following said further updating thereof.
19. The security management system according to any of clauses 1-18, wherein the first user input obtained by the input interface is indicative of the first topological area being one of a site, a building, a floor, a room, and of the relationship being one of a closed connection and an open connection.
20. In some embodiments, a security system for securing a site comprising a plurality of security devices monitoring the site and the physical security management system of any of clauses 1-19.
21. According to some embodiments, a method for establishing a topological model for a site being monitored by a plurality of security devices. The method comprises obtaining first user input defining a first topological area and a relationship between the first topological area and at least one second topological area of the topological model; interpreting the first user input to update the topological model to represent the first topological area and the relationship between the first topological area and the at least one second topological area; and causing display of at least part of the topological model following updating thereof.
22. The method according to clause 21, further comprising obtaining additional user input indicative of a first security device being located within the first area; interpreting the additional user input to create an association between the first area and the first security device; and causing the display device to display a visual representation of the first security device in association with the first area.
23. The method according to clause 21 or clause 22, further comprising storing configuration data associated with the security devices; interpreting additional user input to update the configuration data associated with the security devices; and providing the configuration data to the security devices.
24. The method according to any of clauses 21-23, further comprising obtaining first relationship user input indicative of selection of a first relationship between a first pair of topological areas defined in the topological model; obtaining second relationship user input indicative of a first security device being associated with the first relationship; interpreting the first and second relationship user input to create an association between the first relationship and the first security device; and causing the display device to display a visual representation of the first security device in association with the first relationship.
25. The method according to clause 24, wherein the second relationship user input is further indicative of a second security device being associated with the first relationship, and wherein the method further comprises interpreting the second relationship user input to associate the first security device with a first side of the first relationship and to associate the second security device with a second side of the first relationship, the first and second sides being different.
26. The method according to clause 25, wherein the topological model comprises a graph structure composed of nodes representing areas and edges representing connections between areas, the first and second areas being a represented by a first and second node, respectively, in the topological model, and the first relationship is represented by an edge between the first and second node.
27. The method according to clause 26, wherein the graph structure is a unidirectional graph, wherein the first side of the first relationship is a first edge between the first and second node, and the second side of the first relationship is a second edge between the first and second node.
28. The method according to any of clauses 1-7, wherein the topological model comprises a graph structure composed of nodes representing areas and edges representing connections between areas, the first and second areas being a represented by a first node and a second node, respectively, in the topological model, and a particular relationship being represented by an edge between the first and second nodes.
29. The method according to clause 28, wherein the graph structure is a unidirectional graph.
30. The method according to clause 28 or clause 29, further comprising causing display, via the display device, of a visual representation of a particular security device associated with the relationship between the first topological area and the at least one second topological area as being associated with the edge between the first and second nodes.
31. The method according to any of clauses 28-30, further comprising obtaining third user input indicative of a selection of the edge between the first and second nodes, and responsive to obtaining the third user input, causing display, via the display device, of relationship configuration parameters associated with the relationship between the first and second topological areas.
32. The method according to any of clauses 21-31, wherein the topological model is a hierarchical topological model, the method further comprising creating hierarchical relationships between first level geographical constructs and second level geographical constructs belonging to the first level geographical constructs and defining a hierarchical relationship between a particular first level geographical construct and a particular second level geographical construct belonging to the particular first level geographical construct.
33. The method according to clause 32, wherein the third user input defines the particular first level geographical construct and defines the first area as the particular second level geographical construct.
34. The method according to clause 33, wherein the third user input further defines the second area as another second level geographical construct belonging to the particular first level geographical construct.
35. The method according to clause 33 or clause 34, further comprising causing display, via the display device, of the hierarchical topological model, comprising displaying a visual representation of first area as being nested within a visual representation of the particular first level geographical construct.
36. The method according to any of clauses 21-35, further comprising accessing stored map data and representing the map data as a map on the display device, the map data being distinct from the topological model and defining spatial attributes of the site, the topological model defining logical connectivity relationships for the site.
37. The method according to clause 36, further comprising processing map data to automatically derive therefrom the first topological area and the second topological area and the relationship between the first topological area and the second topological area.
38. The method according to any of clauses 21-37, further comprising obtaining further user input indicative of at least one of a subsequent topological area and a relationship between the subsequent topological area and at least one existing topological area, interpreting the further user input and further updating the topological model to represent the subsequent topological area and the relationship between the subsequent topological area and the at least one existing topological area, and causing display of the at least part of the topological model, including the subsequent topological area, following said further updating thereof.
39. The method according to any of clauses 21-38, wherein the first user input obtained is indicative of the first topological area being one of a site, a building, a floor, a room, and of the relationship being one of a closed connection and an open connection.
40. According to some embodiments, a method for configuring a physical security management system. The method comprising displaying a graphical user interface for receiving user input, the graphical user interface configured to progress through a plurality of pages soliciting user input relating to a site being monitored; obtaining, via a first page of the plurality of pages, first user input indicative of a layout of the site; generating, based on the first user input, a topological model of the site being monitored representative of the layout; obtaining, via a second page of the plurality of pages, second user input indicative of one or more topological areas within the site being monitored; generating, based on the second user input, one or more constituent elements representative of the one or more topological areas within the topological model of the site being monitored; obtaining, via a third page of the plurality of pages, third user input indicative of an association of at least one physical security device with a respective one of the one or more constituent elements; and assigning, based on the third user input, the at least one physical security device to the respective one of the one or more constituent elements within the topological model of the site being monitored.
41. The method according to clause 40, wherein displaying the graphical user interface comprises displaying an index comprising an indicator of a current page within the graphical user interface.
42. The method according to clause 41, wherein displaying the index comprises displaying indicators for the plurality of pages within the graphical user interface.
43. The method according to any of clauses 40-42, wherein the second user input is indicative of a number of buildings composing the site, and wherein generating the one or more constituent elements comprises generating, within the topological model, building nodes corresponding to the number of buildings.
44. The method according to any of clauses 40-43, wherein the second user input is indicative of a number of floors composing a building of the site, and wherein generating the one or more constituent elements comprises generating, within the topological model, floor nodes corresponding to the number of buildings and relationships between the floor nodes and a building node representing the building.
45. The method according to any of clauses 40-44, wherein the second user input is indicative of a number of spaces composing a floor of the site, and wherein generating the one or more constituent elements comprises generating, within the topological model, space nodes corresponding to the number of buildings and relationships between the space nodes and a floor node representing the floor.
46. The method according to any of clauses 40-45, further comprising obtaining, via a fourth page of the plurality of pages, fourth user input indicative of a relationship between a first space and a second space of the site; and generating, based on the fourth user input, a representation of the relationship between the first space and the second space within the topological model.
47. The method according to clause 46, wherein the fourth user input is indicative of a security device mediating the relationship between the first space and the second space, comprising generating an association between the security device and the relationship within the topological model.
48. The method according to clause 47, wherein the fourth user input is indicative of a side of the relationship with which the security device is associated, wherein generating the association comprises associating the security device with one of the first space and the second space.
49. The method according to clause 47 or clause 48, wherein the fourth user input is indicative of the security device being one of an access control reader, a request-to-exit sensor, an entry sensor, a camera, and a door controller.
50. The method according to any of clauses 40-49, further comprising obtaining, via a fourth page of the plurality of pages, fourth user input indicative of a location of the site; and associating the location with the topological model of the site being monitored.
51. The method according to clause 50, wherein the fourth user input comprises a georeferenced location.
52. The method according to clause 50 or clause 51, wherein the fourth user input comprises a civic address.
53. The method according to any of clauses 40-52, further comprising presenting, via a fourth page of the plurality of pages, confirmation information relating to at least some of the first user input, the second user input, and the third user input.
54. The method according to any of clauses 40-53, wherein the topological model comprises a graph structure composed of nodes representing the one or more constituent elements and edges representing relationships between the one or more constituent elements.
55. The method according to any of clauses 40-54, wherein generating one or more constituent elements comprises generating a root node within the topological model as a first constituent element.
56. The method according to clause 55, wherein generating the one or more constituent elements comprises generating one or more leaf nodes, wherein at least one of the leaf nodes is linked to the root node.
57. The method according to any of clauses 40-56, further comprising accessing map data defining a map of the site, the map data being distinct from the topological model and defining spatial attributes of the site, displaying at least a portion of the map data as a map on the graphical user interface, and obtaining via the user input a relationship between at least one constituent element within the topological model and a portion of the map and in response associating the at least one constituent element to the portion of the map.
58. According to some embodiments, a system for configuring a physical security management system, comprising a processor and a non-transitory computer-readable memory containing instructions which, when executed by the processor, cause the system to perform: displaying a graphical user interface for receiving user input, the graphical user interface configured to progress through a plurality of pages soliciting user input relating to a site being monitored; obtaining, via a first page of the plurality of pages, first user input indicative of a layout of the site; generating, based on the first user input, a topological model of the site being monitored representative of the layout; obtaining, via a second page of the plurality of pages, second user input indicative of one or more topological areas within the site being monitored; generating, based on the second user input, one or more constituent elements representative of the one or more topological areas within the topological model of the site being monitored; obtaining, via a third page of the plurality of pages, third user input indicative of an association of at least one physical security device with a respective one of the one or more constituent elements; and assigning, based on the third user input, the at least one physical security device to the respective one of the one or more constituent elements within the topological model of the site being monitored.
59. The system according to clause 58, wherein displaying the graphical user interface comprises displaying an index comprising an indicator of a current page within the graphical user interface.
60. The system according to clause 59, wherein displaying the index comprises displaying indicators for the plurality of pages within the graphical user interface.
61. The system according to any of clauses 58-60, wherein the second user input is indicative of a number of buildings composing the site, and wherein generating the one or more constituent elements comprises generating, within the topological model, building nodes corresponding to the number of buildings.
62. The system according to any of clauses 58-61, wherein the second user input is indicative of a number of floors composing a building of the site, and wherein generating the one or more constituent elements comprises generating, within the topological model, floor nodes corresponding to the number of buildings and relationships between the floor nodes and a building node representing the building.
63. The system according to any of clauses 58-62, wherein the second user input is indicative of a number of spaces composing a floor of the site, and wherein generating the one or more constituent elements comprises generating, within the topological model, space nodes corresponding to the number of buildings and relationships between the space nodes and a floor node representing the floor.
64. The system according to any of clauses 58-63, wherein when executed by the processor, the instructions further cause the system to perform obtaining, via a fourth page of the plurality of pages, fourth user input indicative of a relationship between a first space and a second space of the site; and generating, based on the fourth user input, a representation of the relationship between the first space and the second space within the topological model.
65. The system according to clause 64, wherein the fourth user input is indicative of a security device mediating the relationship between the first space and the second space, comprising generating an association between the security device and the relationship within the topological model.
66. The system according to clause 65, wherein the fourth user input is indicative of a side of the relationship with which the security device is associated, wherein generating the association comprises associating the security device with one of the first space and the second space.
67. The system according to clause 65 or clause 66, wherein the fourth user input is indicative of the security device being one of an access control reader, a request-to-exit sensor, an entry sensor, a camera, and a door controller.
68. The system according to any of clauses 58-67, wherein when executed by the processor, the instructions further cause the system to perform obtaining, via a fourth page of the plurality of pages, fourth user input indicative of a location of the site; and associating the location with the topological model of the site being monitored.
69. The system according to clause 68, wherein the fourth user input comprises a georeferenced location.
70. The system according to clause 68 or clause 69, wherein the fourth user input comprises a civic address.
71. The system according to any of clauses 58-70, wherein when executed by the processor, the instructions further cause the system to perform presenting, via a fourth page of the plurality of pages, confirmation information relating to at least some of the first user input, the second user input, and the third user input.
72. The system according to any of clauses 58-71, wherein the topological model comprises a graph structure composed of nodes representing the one or more constituent elements and edges representing relationships between the one or more constituent elements.
73. The system according to any of clauses 58-72, wherein generating one or more constituent elements comprises generating a root node within the topological model as a first constituent element.
74. The system according to clause 73, wherein generating the one or more constituent elements comprises generating one or more leaf nodes, wherein at least one of the leaf nodes is linked to the root node.
75. The system according to any of clauses 58-74, wherein when executed by the processor, the instructions further cause the system to perform accessing map data defining a map of the site, the map data being distinct from the topological model and defining spatial attributes of the site, displaying at least a portion of the map data as a map on the graphical user interface, and obtaining via the user input a relationship between at least one constituent element within the topological model and a portion of the map and in response associating the at least one constituent element to the portion of the map.

The embodiments of the methods, systems, devices, and computer-readable media described herein may be implemented in a combination of both hardware and software. These embodiments may be implemented on programmable computers, each computer including at least one processor, a data storage system (including volatile memory or non-volatile memory or other data storage elements or a combination thereof), and at least one communication interface.

Program code is applied to input data to perform the functions described herein and to generate output information. The output information is applied to one or more output devices. In some embodiments, the communication interface may be a network communication interface. In embodiments in which elements may be combined, the communication interface may be a software communication interface, such as those for inter-process communication. In still other embodiments, there may be a combination of communication interfaces implemented as hardware, software, and combination thereof.

Throughout the foregoing discussion, numerous references have been made regarding servers, services, interfaces, portals, platforms, or other systems formed from computing devices. It should be appreciated that the use of such terms is deemed to represent one or more computing devices having at least one processor configured to execute software instructions stored on a computer readable tangible, non-transitory medium. For example, a server can include one or more computers operating as a web server, database server, or other type of computer server in a manner to fulfill described roles, responsibilities, or functions.

The foregoing discussion provides many example embodiments. Although each embodiment represents a single combination of inventive elements, other examples may include all possible combinations of the disclosed elements. Thus, if one embodiment comprises elements A, B, and C, and a second embodiment comprises elements B and D, other remaining combinations of A, B, C, or D, may also be used.

The terms "connected" or "coupled to", as well as any similar terms, may include both direct coupling (in which two elements that are coupled to each other contact each other) and indirect coupling (in which at least one additional element is located between the two elements).

The use of numerical ranges by endpoints in the present disclosure should be understood as including all numbers within that range (e.g., 1 to 5 includes 1, 1.25, 2, 2.5, 3, 3.69, 4, 4.33, 5, etc.). Where a range of values is qualified as being "greater than", "less than", etc., of a particular value, that value may or may not be included within the range, as appropriate.

Any direction or orientation described in the present disclosure, including but not limited to "top", "bottom", "left", "right", "upper", "lower", "above", below", as well as other directions and orientations, are described herein for clarity, and should be understood in reference to the drawings. These and other similar terms should not be understood as limiting of an actual device or system or of use of the device or system. Many of the devices, articles, or systems described in the present disclosure may be used in a number of suitable directions and orientations.

Any citation to references in this disclosure and during the prosecution thereof is made out of an abundance of caution. No citation should be construed as an admission that the cited reference qualifies as prior art or comes from an area that is analogous or directly applicable to the present teachings.

To aid the Patent Office, as well as any readers of any patent issued from this application, in interpreting the claims appended hereto, it is noted that none of the appended claims or elements of the appended claims, as pending or as granted, are intended to invoke 35 U.S.C. 112(f) unless the words "means for" or "step for" are explicitly used in the particular claim or claim or claim element.

The technical solution of embodiments may be in the form of a software product. The software product may be stored in a non-volatile or non-transitory computer-readable storage medium, which can be a compact disk read-only memory (CD-ROM), a USB flash disk, or a removable hard disk. The software product includes a number of instructions that enable a computer device (personal computer, server, or network device) to execute the methods provided by the embodiments.

The embodiments described herein are implemented by physical computer hardware, including computing devices, servers, receivers, transmitters, processors, memory, displays, and networks. The embodiments described herein provide useful physical machines and particularly configured computer hardware arrangements. The embodiments described herein are directed to electronic machines and methods implemented by electronic machines adapted for processing and transforming electromagnetic signals which represent various types of information. The embodiments described herein pervasively and integrally relate to machines, and their uses; and at least some of the embodiments described herein have no meaning or practical applicability outside their use with computer hardware, machines, and various hardware components. Substituting the physical hardware particularly configured to implement various acts for non-physical hardware, using mental steps for example, may substantially affect the way the embodiments work. Such computer hardware limitations are clearly essential elements of the embodiments described herein, and they cannot be omitted or substituted for mental means without having a material effect on the operation and structure of the embodiments described herein. The computer hardware is essential to implement the various embodiments described herein and is not merely used to perform steps expeditiously and in an efficient manner.

Although the embodiments have been described in detail, it should be understood that various changes, substitutions, and alterations can be made herein without departing from the scope as defined by the appended claims.

Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed, that perform substantially the same function or achieve substantially the same result as the corresponding embodiments described herein may be utilized. Accordingly, the examples described above and illustrated herein are intended to be examples only, and the appended claims are intended to include within their scope such processes, machines, manufacture, compositions of matter, means, methods, or steps.

Generally, all terms used in the claims are to be interpreted according to their ordinary meaning in the relevant technical field, unless explicitly defined otherwise herein. All references to a/an/the element, apparatus, component, means, step, etc., are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second", etc. for different features/components of the present disclosure are only intended to distinguish the features/components from other similar features/components and not to impart any order or hierarchy to the features/components.

## Claims

1. A physical security management system for securing a site monitored by security devices, comprising:
a topology database storing a topological model of the site;
a network interface adapted for obtaining security data from the security devices;
an input interface adapted for obtaining first user input from an input device defining first topological area and a relationship between the first topological area and at least one second topological area;
a topology management engine coupled to the topological database, the topology management engine adapted for interpreting the first user input to configure the topological model to represent the first topological area and the relationship between the first topological area and the at least one second topological area; and
an output interface adapted for causing display, via the display device, of at least part of the topological model following said updating thereof.

2. The security management system of claim 1, wherein
the input interface is adapted for obtaining additional user input indicative of a first security device being located within the first area;
the topology management engine is adapted for interpreting the additional user input to create an association between the first area and the first security device; and
the output interface is adapted for causing the display device to display a visual representation of the first security device in association with the first area.

3. The security management system of claim 1 or 2 , comprising:
a configuration database storing configuration data associated with the security devices;
a configuration management engine coupled to the configuration database, the configuration management engine adapted for interpreting additional user input to update the configuration data associated with the security devices;
wherein the network interface is adapted for providing the configuration data to the security devices.

4. The security management system of any of the preceding claims, wherein
the input interface is adapted for obtaining first relationship user input indicative of selection of a first relationship between a first pair of topological areas defined in the topological model;
the input interface is adapted for obtaining second relationship user input indicative of a first security device being associated with the first relationship;
the topology management engine is adapted for interpreting the first and second relationship user input to create an association between the first relationship and the first security device; and
the output interface is adapted for causing the display device to display a visual representation of the first security device in association with the first relationship.

5. The security management system of claim 4, wherein the second relationship user input is further indicative of a second security device being associated with the first relationship, and wherein the topology management engine is adapted for interpreting the second relationship user input to associate the first security device with a first side of the first relationship and to associate the second security device with a second side of the first relationship, the first and second sides being different.

6. The security management system of any of the preceding claims, wherein the topological model comprises a graph structure composed of nodes representing areas and edges representing connections between areas, the first and second areas being represented by a first and second node, respectively, in the topological model, and the first relationship is represented by an edge between the first and second node.

7. The security management system of claim 6, wherein the graph structure is a unidirectional graph, wherein the first side of the first relationship is a first edge between the first and second node, and the second side of the first relationship is a second edge between the first and second node.

8. The security management system of any of the preceding claims, wherein the topological model comprises a graph structure composed of nodes representing areas and edges representing connections between areas, the first and second areas being represented by a first node and a second node, respectively, in the topological model, and a particular relationship being represented by an edge between the first and second nodes.

9. The security management system of any of the preceding claims, wherein the topological model is a hierarchical topological model, the topology management engine being adapted for creating hierarchical relationships between first level geographical constructs and second level geographical constructs belonging to the first level geographical constructs, the input interface adapted for obtaining third user input defining a hierarchical relationship between a particular first level geographical construct and a particular second level geographical construct belonging to the particular first level geographical construct.

10. The security management system of any of the preceding claims, further comprising a map representation component adapted for accessing stored map data and representing the map data as a map on the display device via the output interface, the map data being distinct from the topological model and defining spatial attributes of the site, the topological model defining logical connectivity relationships for the site.

11. The security management system of claim 10, further comprising a component adapted for processing map data to automatically derive therefrom the first topological area and the second topological area and the relationship between the first topological area and the second topological area.

12. A method for establishing a topological model for a site being monitored by a plurality of security device, comprising:
obtaining first user input defining a first topological area and a relationship between the first topological area and at least one second topological area of the topological model;
interpreting the first user input to update the topological model to represent the first topological area and the relationship between the first topological area and the at least one second topological area; and
causing display of at least part of the topological model following updating thereof.

13. The method of claim 12, further comprising:
obtaining additional user input indicative of a first security device being located within the first area;
interpreting the additional user input to create an association between the first area and the first security device; and
causing the display device to display a visual representation of the first security device in association with the first area.

14. The method of claim 12 or 13, further comprising:
storing configuration data associated with the security devices;
interpreting additional user input to update the configuration data associated with the security devices; and
providing the configuration data to the security devices.

15. The method of any of the preceding claims 12 to 14, further comprising:
obtaining first relationship user input indicative of selection of a first relationship between a first pair of topological areas defined in the topological model;
obtaining second relationship user input indicative of a first security device being associated with the first relationship;
interpreting the first and second relationship user input to create an association between the first relationship and the first security device; and
causing the display device to display a visual representation of the first security device in association with the first relationship.

16. The method of claim 15, wherein the second relationship user input is further indicative of a second security device being associated with the first relationship, and wherein the method further comprises interpreting the second relationship user input to associate the first security device with a first side of the first relationship and to associate the second security device with a second side of the first relationship, the first and second sides being different.

17. The method of any of the preceding claims 12 to 16, wherein the topological model comprises a graph structure composed of nodes representing areas and edges representing connections between areas, the first and second areas being a represented by a first and second node, respectively, in the topological model, and the first relationship is represented by an edge between the first and second node.

18. The method of claim 17, wherein the graph structure is a unidirectional graph, wherein the first side of the first relationship is a first edge between the first and second node, and the second side of the first relationship is a second edge between the first and second node.

19. The method of any of the preceding claims 12 to 18, wherein the topological model comprises a graph structure composed of nodes representing areas and edges representing connections between areas, the first and second areas being a represented by a first node and a second node, respectively, in the topological model, and a particular relationship being represented by an edge between the first and second nodes.

20. The method of any of the preceding claims 12 to 19, wherein the topological model is a hierarchical topological model, the method further comprising creating hierarchical relationships between first level geographical constructs and second level geographical constructs belonging to the first level geographical constructs and defining a hierarchical relationship between a particular first level geographical construct and a particular second level geographical construct belonging to the particular first level geographical construct
